Europäisches Patentamt

European Patent Office

Office européen des brevets

(19)

(11) **EP 1 272 006 A1**

(12) **EUROPEAN PATENT APPLICATION**
published in accordance with Art. 158(3) EPC

(43) Date of publication:
**02.01.2003 Bulletin 2003/01**

(21) Application number: **01917811.0**

(22) Date of filing: **03.04.2001**

(51) Int Cl.⁷: **H05B 3/10**, H05B 3/16,
H05B 3/20, H01L 21/027

(86) International application number:
**PCT/JP01/02898**

(87) International publication number:
**WO 01/078454 (18.10.2001 Gazette 2001/42)**

(84) Designated Contracting States:
**AT BE CH CY DE DK ES FI FR GB GR IE IT LI LU
MC NL PT SE TR**

(30) Priority: **07.04.2000 JP 2000144123
29.11.2000 JP 2000363666
23.02.2001 JP 2001048976
23.02.2001 JP 2001048978**

(71) Applicant: **IBIDEN CO., LTD.
Ogaki-shi Gifu-ken 503-0917 (JP)**

(72) Inventors:
• **ITO, Yasutaka
Ibi-gun Gifu 501-0695 (JP)**
• **SAKAGUCHI, Hiroyuki c/o Ibiden Co., Ltd.
Ibi-gun Gifu 501-0695 (JP)**

(74) Representative: **Gillard, Marie-Louise et al
Cabinet Beau de Loménie
158, rue de l'Université
75340 Paris Cédex 07 (FR)**

(54) **CERAMIC HEATER**

(57) An object of the present invention is to provide a ceramic heater making it possible to make the temperature of a face for heating a silicon wafer even and prevent damage of the silicon wafer. The ceramic heater of the present invention is a ceramic heater comprising resistance heating elements formed on a surface of a ceramic substrate in a disc form or inside the ceramic substrate, wherein the resistance heating elements composed of two or more circuits being divided in the circumferential direction are arranged in the outermost periphery of the ceramic substrate and further the resistance heating element composed of a different circuit is formed in the inner portion of the resistance heating elements being arranged in the peripheral portion.

Fig.1

EP 1 272 006 A1

**Description**

Technical Field

The present invention relates to a ceramic heater for drying, sputtering and the like , usedmainly in the semiconductor industry, and particularly to a ceramic heater wherein the temperature thereof can easily be controlled and the temperature evenness of its heating face is superior.

Background Art

A semiconductor product is produced through the step of forming a photosensitive resin as an etching resist on a semiconductor wafer and subjecting the semiconductor wafer to etching, and the like steps.

This photosensitive resin is liquid, and is applied onto a surface of the semiconductor wafer using a spin coater and the like. After the application, the resin must be dried. Thus, the semiconductor wafer subjected to the application is put on a heater and heated.

Hitherto, as a heater made of metal and used for such a purpose, a heater wherein a resistance heating element was arranged on the back face of an aluminum plate was adopted.

However, such a heater made of metal has the following problems.

First, the thickness of the ceramic substrate must be as thick as about 15 mm since the ceramic substrate is made of metal. This is because, in a thin metal plate, a bend or a strain is generated because of thermal expansion resulting from heating so that a semiconductor wafer put on the metal plate is damaged or inclined. However, if the thickness of the ceramic substrate is made thick, the heater becomes heavy and bulky.

Heating temperature is controlled by changing the voltage or amperage applied to the resistance heating elements. However, since the metal plate is thick, the temperature of the ceramic substrate does not follow the change in the voltage or amperage promptly. Thus, the temperature thereof cannot be easily controlled.

Thus, as suggested in JP Kokoku Hei 8-8247, JP Kokai Hei 11-40330 and so on, there are suggested techniques of performing a temperature-control of a nitride ceramic with which a resistance heating element is formed, by measuring the temperature near the resistance heating element.

Summary of the Invention

However, when a semiconductor wafer is attempted to be heated using such a technique, a temperature difference is generated on the heating face of the ceramic heater. Particularly, when a ceramic heater in which a resistance heating elements is formed into a concentric circles-like or a spiral shape is used, a temperature difference becomes large between the central portion and the peripheral portion of the heated semiconductor wafer to result in a problem that the degree of curing of resin to be cured on the semiconductor wafer becomes uneven or the semiconductor wafer is damaged by thermal impact attributed to the temperature difference on the heater surface.

Even in case where respective temperatures of portions near resistance heating elements composed of circuits are measured to improve the precision of temperature-control and then respectively different electric currents are passed through the respective resistance heating elements, still, a temperature difference on the heating face may be generated as well.

Thus, the inventors made eager investigations on causes of such cases in which: the degree of curing of the resin to be cured on such a semiconductor wafer became uneven; or the semiconductor wafer was damaged. As a result, the inventors have found out the fact that the reason why such a problem arises regardless of temperature-control is that even if a single temperature-control is performed, the heating face is not able to have even temperature so that a temperature difference is generated dependently on locations on the semiconductor wafer.

Also, the inventors have found out that in the peripheral portion of the ceramic substrate (portion outer from 1/2 of the diameter of the ceramic substrate), the temperature thereof easily becomes uneven by heat radiation from the outer rim portion of the ceramic substrate. Particularly in the process in which the temperature rises (transient property), this tendency becomes significant.

As a result of further eager investigations on causes that such a temperature distribution is generated on a heating face, the inventors have found out that the reason why such a problem is caused regardless of the temperature-control is that the number of the circuits comprising the resistance heating elements formed in the ceramic substrate is not appropriate to the size (diameter) of the substrate.

Furthermore, the inventors have found out the fact that such unevenness in the temperature becomes larger in a more peripheral portion of the ceramic substrate, where heat radiates more largely, and that if a ceramic substrate having a high thermal conductivity, such as a ceramic nitride or a ceramic carbide, is used, the tendency of the unevenness in the temperature increases.

As a result of further investigations, the inventors have found out that by using a ceramic heater in which a resistance heating element composed of two or more circuits is arranged in the peripheral portion of a ceramic substrate (the portion outer from 1/2 of the diameter of the ceramic substrate) and further the resistance heating element composed of a different circuit is formed in the inner portion of the ceramic substrate (the portion inner from 1/2 of the diameter of the ceramic substrate) , and performing detailed control of calorific value, a temperature difference on a heating face for an object to be heated, such as a semiconductor wafer, (referred to as a heating face hereinafter) can be made small so that the semiconductor wafer can be prevented from being damaged. Thus, the first aspect of the present invention has been completed.

The inventors have also found out that by:

forming the resistance heating element composed of: circuits being divided in the circumferential direction; or circuits having a concentric circles-like or spiral pattern; and
further setting the total number of the circuits to 3 or more,
a temperature difference on a heating face of an object to be heated, such as a semiconductor wafer, can be made small. Thus, the second aspect of the present invention has been completed.

Furthermore, the inventors have found out that a given relationship holds between the diameter of the ceramic substrate and an appropriate total number of the circuits of the resistance heating elements formed on the ceramic substrate. Thus, the third aspect of the present invention has been completed.

That is, the ceramic heater of the first aspect of the present invention is a ceramic heater comprising a disc shaped ceramic substrate and a resistance heating element formed: on a surface of the ceramic substrate; or inside the ceramic substrate,
    wherein:

the resistance heating element composed of two or more circuits being divided in the circumferential direction is arranged in the outermost periphery of the ceramic substrate; and
further the resistance heating element composed of a different circuit is formed in the inner portion of the resistance heating element being arranged in the peripheral portion.

In the first aspect of the present invention, it is desired that a relationship of the following expression (1) holds between the total number n of the circuits of the resistance heating element provided for the ceramic substrate and the diameter r (mm) of the ceramic substrate:

$$n \geqq r^{1.94} \times 0.5 \times 10^{-4} \tag{1}$$

In the first aspect of the present invention, it is also desired that the resistance heating element composed of a different circuit has a concentric circles-like or a spiral shape.

In the first aspect of the present invention, it is also desired that the resistance heating element composed of a different circuit is a combination of: a resistance heating element having a concentric circles-like or a spiral shape; and resistance heating elements being divided in the circumferential direction.

The ceramic heater of the second aspect of the present invention is a ceramic heater comprising a disc shaped ceramic substrate having a diameter of 200 mm or more and a resistance heating element composed of two or more circuits formed: on a surface of the ceramic substrate; or inside the ceramic substrate,
    wherein:

at least one of circuits of the resistance heating element is divided in the circumferential direction;
at least one of circuits of the resistance heating element contains a concentric circles-like or spiral pattern; and
further the total number of the circuits of the resistance heating element is 3 or more.

The ceramic heater of the third aspect of the present invention is a ceramic heater comprising a disc shaped ceramic substrate and a resistance heating element composed of two or more circuits formed: on a surface of the ceramic substrate; or inside the ceramic substrate,
    wherein:

at least one of circuits of the resistance heating element is divided in the circumferential direction;
at least one of circuits of the resistance heating element contains a concentric circles-like or spiral pattern; and

further a relationship of the following expression (2) holds between the total number n of the circuits of the resistance heating element and the diameter r (mm) of the ceramic substrate:

$$n \geqq r^{1.94} \times 10^{-4} \tag{2}.$$

Also, in the first, second and third aspect of the present inventions, it is desired that the ceramic heater is used at a temperature of 100 to 800 °C.

Also, in the first, second and third aspect of the present inventions, it is desired that the ceramic heater is equipped with:

a temperature-measuring element for measuring the temperature of the ceramic substrate;
a control unit for supplying electric power to the resistance heating element composed of a plurality of circuits;
a memory unit for memorizing the data of a temperature measured by the temperature-measuring element; and
an operation unit for calculating electric power required for the resistance heating element from the temperature data measured by the temperature-measuring element,
the ceramic heater being constituted such that respectively different electric powers are supplied to the plurality of circuits of the resistance heating element.

Further, in the first, second and third aspect of present inventions, it is desired that the ceramic substrate is constituted of a nitride ceramic or a carbide ceramic.

Incidentally, in case where it is not particularly necessary to distinguish the first, second and third aspect of the present inventions from each other, each of them will be referred to as the present invention hereinafter.

Brief Description of the Drawings

FIG. 1 is a bottom face view schematically illustrating a pattern of a resistance heating element of a ceramic heater of the present invention.
FIG. 2 is a partially-enlarged sectional view of the ceramic heater illustrated in FIG. 1.
FIG. 3 is a block view schematically illustrating another example of the ceramic heater of the present invention.
FIG. 4 is a bottom face view schematically illustrating a pattern of a resistance heating element of a ceramic heater of the present invention.
FIG. 5 is a partially-enlarged sectional view of the ceramic heater illustrated in FIG. 4.
FIG. 6 are sectional views schematically illustrating a part of the process for producing a ceramic heater of the present invention, wherein resistance heating elements are formed on its bottom face.
FIG. 7 is a bottom view schematically illustrating a pattern of a resistance heating element of ceramic heaters according to Comparative Examples 1 and 4.
FIG. 8 is a bottom view schematically illustrating a pattern of a resistance heating element of ceramic heaters of the second and third aspects of the present invention.
FIG. 9 is a bottom view schematically illustrating a pattern of a resistance heating element of a ceramic heater of the present invention.
FIG. 10 is a bottom view schematically illustrating a pattern of a resistance heating element of a ceramic heater in JP Kokai Hei 8-125001.

Explanation of Symbols

| | |
|---|---|
| 10, 40, 50, 60, 70, 80 | ceramic heater |
| 11, 41, 51, 61, 71, 81 | ceramic substrate |
| 11a, 41a | heating face |
| 11b, 41b | bottom face |
| 12(12a to 12j), 42(42a, 42b), 52(52a to 52h) | resistance heating element |
| 120, 420 | metal covering layer |

| 14, 44, 54 | bottomed hole |
| 15, 45, 55 | through hole |
| 17, 47 | thermocouple |
| 20 | socket |
| 21 | memory unit |
| 22 | operation unit |
| 23 | control unit |
| 33, 43 | external terminal |
| 36 | lifter pin |
| 39 | semiconductor wafer |

Detailed Disclosure of the Invention

The ceramic heater of the first aspect of the present invention will be described hereinafter.

The ceramic heater comprising a disc shaped ceramic substrate and a resistance heating element formed: on a surface of the ceramic substrate; or inside the ceramic substrate,

wherein:

the resistance heating element composed of two or more circuits being divided in the circumferential direction is arranged in the outermost periphery of the ceramic substrate; and
further the resistance heating element composed of a different circuit is formed in the innerportion of the resistance heating element being arranged in the peripheral portion.

According to the above-mentioned ceramic heater, the resistance heating element composed of the two or more circuits being divided in the circumferential direction is arranged in the outermost periphery of the ceramic substrate, where unevenness in temperature becomes large; therefore, more detailed control of calorific value can be controlled in the peripheral portion of the ceramic substrate, where the amount of radiation heat is large and temperature easily becomes uneven, so that the temperature of its heating face can be made even. Consequently, an object to be heated can be evenly heated. As a result, for example, the degree of curing of a resin to be cured on a semiconductor wafer can be made even, and the semiconductor wafer is prevented from being damaged.

In the ceramic heater of the first aspect of the present invention, the peripheral portion of the ceramic substrate has the resistance heating element divided into the two or more circuits in the circumferential direction. The reason why such a structure is adopted is that according to circuits composed of, for example, only concentric circles, it is difficult to control the temperature of the heating face. By dividing the above-mentioned resistance heating element to the two or more circuits in the circumferential direction and performing control in this way, unevenness in temperature distribution on the same circumference can be removed and the temperature of the face for heating an object to be heated (heating face) can be made even. Temperature easily becomes uneven particularly near the periphery because of heat radiation. Therefore, the resistance heating elements in the peripheral portion are made to resistance heating elements being divided to two or more circuits in the circumferential direction.

In this case, it is unnecessary that the above-mentioned resistance heating elements being divided to the two or more circuits in the circumferential direction are present in the whole of the peripheral portion, and it is sufficient that they are present in an area of the peripheral portion.

Furthermore, the resistance heating elements being divided to the two ore more circuits in the circumferential direction may be in the inner portion as well as in the peripheral portion.

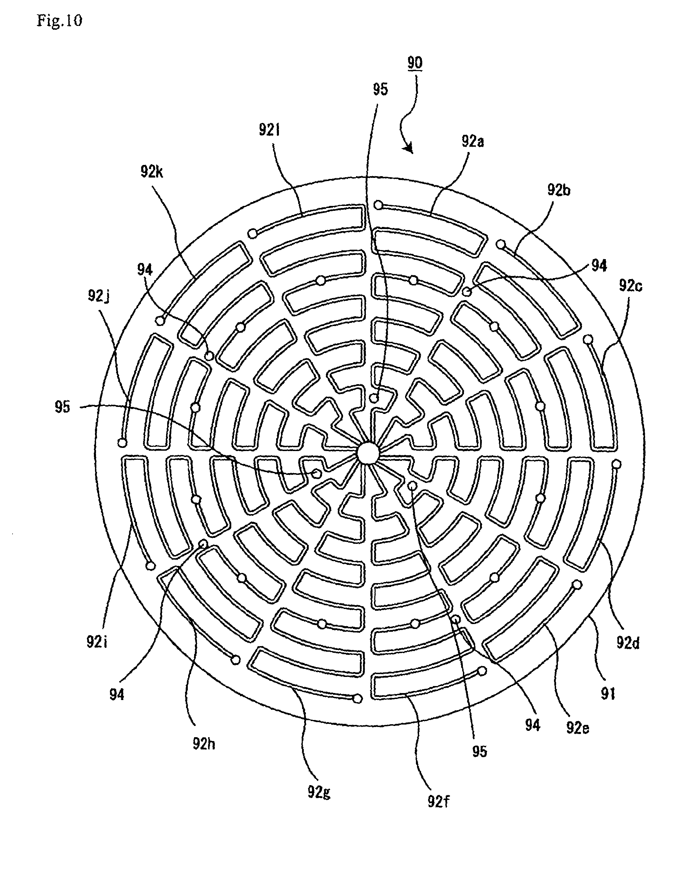

However, the ceramic heater of the first aspect of the present invention does not include any case in which resistance heating elements 92a to 921 are continuous in inner and outer portions and are circuits being divided in the circumferential direction (reference to FIG. 10) , as seen in the ceramic heater in JP Kokai Hei 8-125001. This is because in ceramic heaters having such a structure, temperature becomes uneven in the diameter direction in the inner portion of its ceramic substrate and further a warp of the ceramic substrate is easily generated.

The amount of the warp of the ceramic substrate is desirably 60 μm or less.

If the warp amount is over 60 μm, dispersion in the distance between a semiconductor wafer, which is an object to be heated, and the ceramic substrate becomes large. Therefore, the semiconductor wafer cannot be evenly heated.

The method of heating the semiconductor wafer is classified into 2 kinds : one of which is a method by putting the semiconductor wafer directly on the ceramic substrate and heating the wafer, and the other of which is a method by separating the semiconductor wafer and the ceramic substrate 5 to 5000 μm apart from each other and heating the wafer. In either case, it is preferred that the warp amount of the ceramic substrate is 60 μm or less.

In the ceramic heater of the first aspect of the present invention, the resistance heating element composed of the circuits having the different pattern is formed in the inner portion of the resistance heating elements being arranged in the peripheral portion.

As such a resistance heating element, a resistance heating element having a concentric circles-like or spiral pattern is desired. This is because unevenness in the temperature of the ceramic substrate in the diameter direction can be overcome and further a warp of the ceramic substrate can be prevented.

Particularly in the inner portion (portion inner from 1/2 of the radius of the ceramic substrate), unevenness in temperature is more easily generated in the diameter direction than in the circumferential direction; therefore, the circuit in the inner portion desirably has a concentric circles-like or spiral pattern.

In the inner portion of the ceramic substrate, the resistance heating element having the concentric circles-like or spiral pattern is desirably combined with the resistance heating elements being divided to the two or more circuits in the circumferential direction. This is because unevenness in the temperature of the inner portion of the ceramic substrate is overcome and further a warp of the ceramic substrate can be prevented.

It is therefore desired that in the ceramic heater of the first aspect of the present invention the resistance heating elements being divided to the two or more circuits in the circumferential direction are formed in the peripheral portion and the resistance heating element having the concentric circles-like or spiral pattern is formed in the inner portion.

These resistance heating elements work together in integrated manner, whereby the temperature of the heating face of the ceramic substrate becomes even. Additionally, no warp is generated in the ceramic substrate so that the distance between the ceramic substrate and the semiconductor wafer becomes constant. As a result, the semiconductor wafer can be evenly heated.

In the ceramic heater of the first aspect of the present invention, it is possible to overcome unevenness on the heating face of the ceramic substrate generated particularly in the process in which temperature rises up (transient property).

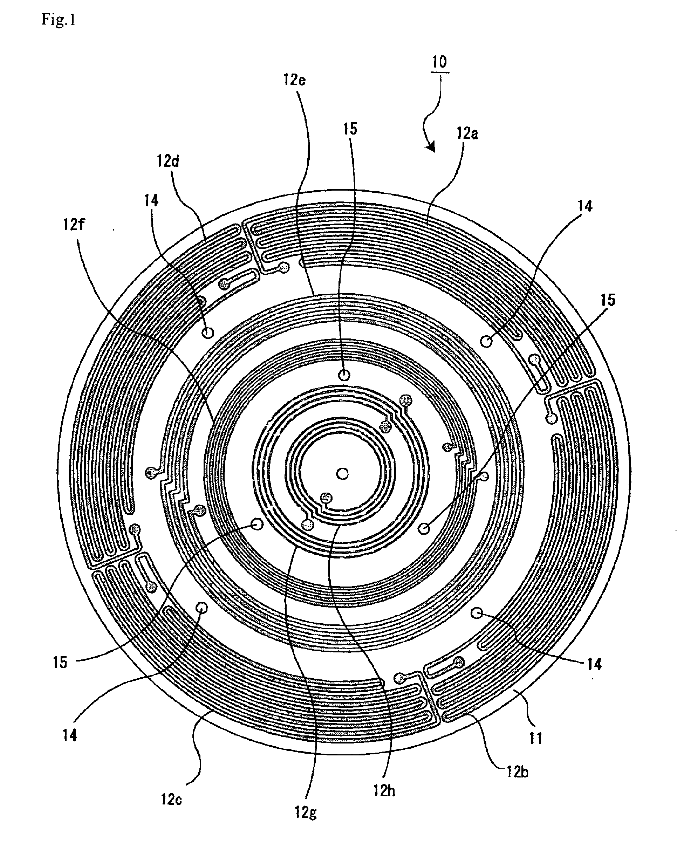

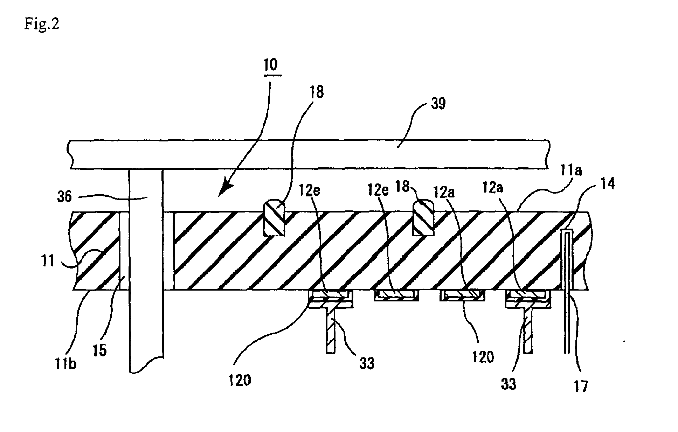

FIG. 1 is a bottom face view schematically illustrating one example of the ceramic heater of the first aspect of the present invention, and FIG. 2 is a partially-enlarged sectional view illustrating a part thereof.

In this ceramic heater 10, resistance heating elements 12 (12a to 12h) are formed on a bottom face 11b, which is an opposite face to a heating face 11a of a ceramic substrate 11 formed into a disc form.

The resistance heating elements 12 generate heat in such a manner that the temperature of the heating face 11a becomes even as a whole. Therefore, a circular arc pattern formed so as to draw a part of concentric circles repeatedly is arranged in the outermost periphery of the ceramic substrate 11 and a concentric circles-like pattern which is cut in a portion is arranged in the inside thereof.

In the resistance heating element 12a at outermost periphery, circular arc-like pattern obtained by dividing concentric circles into 4 parts in the circumferential direction are repeatedly formed, and ends of the circular arcs adjacent to each other are connected through a curved line to constitute a series of circuits. The four resistance heating elements 12a to 12d having patterns identical to this heating element 12a are formed close to each other to surround the periphery. Thus, a pattern in a circular ring form is formed as a whole.

End portions of the resistance heating elements 12a to 12d are formed inside the circular ringpattern in order to prevent the generation of cooling spots and so on. Therefore, end portions of the outer circuits are extended inwards.

In the inner portion of the resistance heating elements 12a to 12d formed in the outermost periphery, resistance heating elements 12e to 12h composed of circuits having a pattern of concentric circles wherein only a small part thereof is cut are formed. In the resistance heating elements 12e to 12h, ends of the concentric circles adjacent to each other are successively connected through linear resistance heating elements to constitute a series of circuits.

Heating element non-formed areas in a belt form (in a circular ring form) are located between each of the resistance heating elements 12a to 12d, 12e, 12f, 12g and 12h, and a circular heating element non-formed area is also located in the central portion.

Therefore, when the whole thereof is viewed, resistance heating element formed areas in the form of circular rings and the heating element non-formed areas are alternately formed from the outside to the inside. By setting these areas appropriately under consideration of the size (diameter) and the thickness of the ceramic substrate, and so on, the temperature of the heating face can be made even.

External terminals 33, which will be terminals for input and output, are connected to both ends of the resistance heating element 12 (12a to 12h) through a metal covering layer 120. Through holes 15, into which lifter pins 36 for supporting a semiconductor wafer 39 will be inserted, are made near the center, and further bottomed holes 14, into which thermocouples 17 as temperature-measuring element will be inserted, are made.

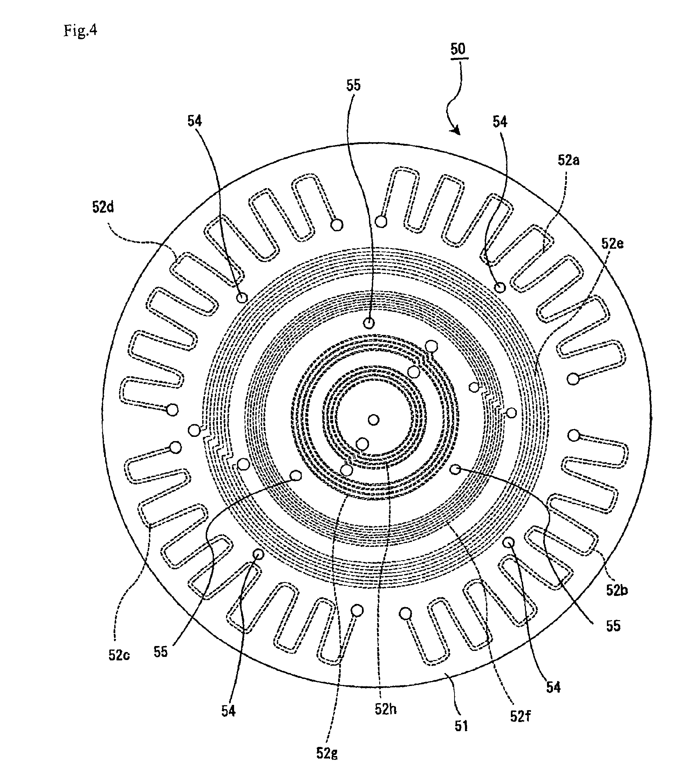

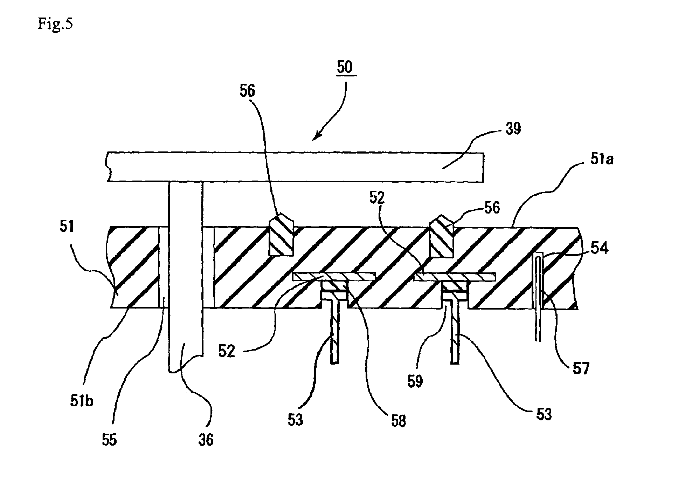

FIG. 4 is a bottom face view schematically illustrating another example of the ceramic heater of the first aspect of the present invention. FIG. 5 is a partially-enlarged sectional view of a part thereof.

In this ceramic heater 50, resistance heating elements 52 (52a to 52h) are formed inside a ceramic substrate 51 having a disc shape.

In the outermost periphery of the ceramic heater 50, the resistance heating elements 52a to 52d composed of a repeated pattern of a bending line, which is divided into 4 pieces, are arranged. In the inner portion of it, the resistance heating elements 52e to 52h composed of circuits having a pattern of concentric circles are arranged at regular intervals.

In the same manner as in the ceramic heater illustrated in FIG. 1, plural through holes 55 are made and further plural bottomed holes 54 are made. Conductor filled through holes 58 are made just under ends of the resistance heating elements 52a to 52h. Furthermore, blind holes 59 formakingthe plated through holes 58 exposed are made in a bottom face 51b, and external terminals 53 are inserted into the blind holes 59. They are jointed with a brazing material (not illustrated).

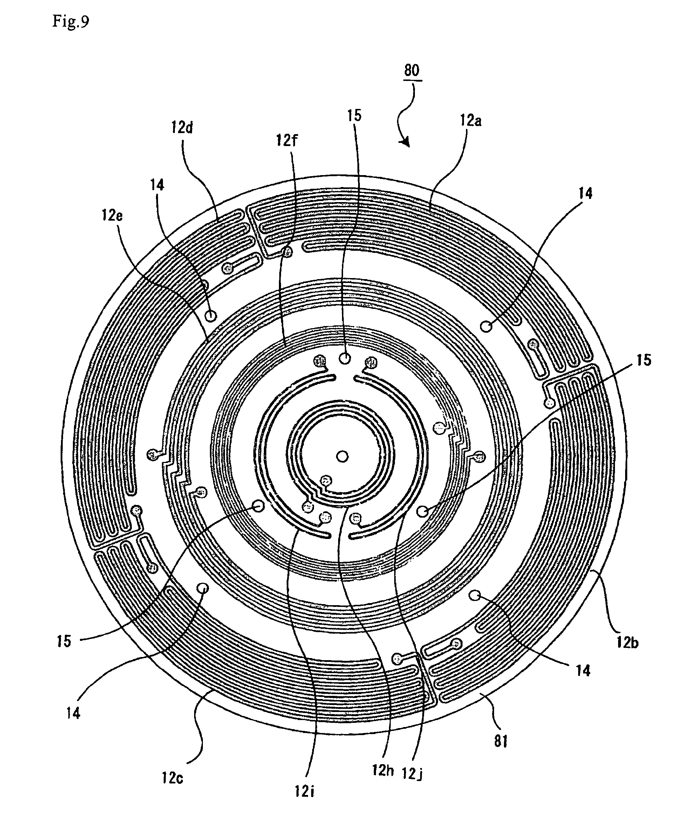

FIG. 9 is a bottom view schematically illustrating a further example of the ceramic heater of the first aspect of the present invention.

As illustrated in FIG. 9, resistance heating elements 12i and 12j being divided in the circumferential direction are formed in the inner portion of a ceramic substrate 81. In this case, it is possible to overcome unevenness in the temperature, along the circumferential direction, of the inner portion of the ceramic substrate 81.

The ceramic heater of the first aspect of the present invention is desirably used at a temperature of 100 to 800 °C.

The resistance heating elements in FIGs. 1 and 4 are the resistance heating elements 12a to 12d, and 52a to 52d arranged in the outermost periphery. Such resistance heating elements in the outermost periphery are desirably formed in the area within 50% or more of the distance from the center to the edge. In case of the distance being less than 50%, the area of the resistance heating elements formed in the outermost periphery is too wide. Thus, it is difficult to control the temperature of the heating face.

The pattern divided in the circumferential direction is a pattern formed in areas obtained by drawing plural lines from the center of the ceramic substrate to the periphery thereof and dividing the ceramic substrate by the lines. Usually, all of the areas preferably have the same size. The number of the divided areas is not limited to 4, as illustrated in FIG. 1. The number may be 2 or more, for example, 3 or 5. Usually, the number is preferably made larger as the size of the ceramic substrate becomes larger. For example, in a substrate having a diameter of 250 mm, the circuits of the resistance heating elements are desirably divided into 2 to 4. In a substrate having a diameter of 300 mm, the circuits of the resistance heating elements are desirably divided into 2 to 8.

The shape of the pattern of the resistance heating elements is not particularly limited if the resistance heating elements composed of at least two circuits being divided in the circumferential direction are arranged in the outermost periphery of the ceramic substrate and a different circuit is formed in the inner portion of the resistance heating elements being arranged in the outermost periphery. Examples thereof include a pattern wherein a pattern of repeated circular arcs and a pattern of concentric circles are used together, illustrated in FIG. 1; and a pattern wherein the resistance heating elements 52a to 52d, which are in a repeated pattern of a bending line, are formed in the outermost periphery and the resistance heating elements 52e to 52h, which are in a pattern of concentric circles, are formed in the inner portion of them, as illustrated in FIG. 4, and the like.

It is also possible to use, for example, a spiral pattern, a pattern of eccentric circles, and a pattern of repeated bending lines. These may be combined with each other, and they may be combined with the pattern illustrated in FIG. 1 or 4.

Furthermore, the pattern of the resistance heating elements being divided in the circumferential direction may be formed not only in the outermost periphery of the ceramic substrate but also in the inner portion of the peripheral poriton.

In the resistance heating elements 12 in the ceramic substrate 10 of the first aspect of the present invention, it is desired that a relationship of the following expression (1) holds between the total number n of the circuits of the resistance heating elements 12 formed in the ceramic substrate 11 and the diameter r (mm) of the ceramic substrate 11:

$$n \geqq r^{1.94} \times 0.5 \times 10^{-4} \tag{1}$$

If the resistance heating elements wherein the relationship of the expression (1) holds are made, the total number of the circuits of the resistance heating elements to the area of the heating face of the ceramic substrate is sufficiently large so that the area any one of the circuits is supposed to heat is within an appropriate range. Therefore, dispersion in calorific value inside any one of the circuits can be made small. As a result, by supplying different electric currents to the respective circuits, detailed control of the calorific value can be easily and precisely performed so that the temperature of the heating face 11a can be made even.

Contrarily, if the relationship of the expression (1) does not hold, the total number of the circuits of the resistance heating elements per the area of the heating face of the ceramic substrate is small so that the area which any one of the circuits is supposed to heat is wide. Therefore, even if different electric currents are supplied to the respective circuits, dispersion in calorific value is generated inside any one of the circuits. As a result, it is difficult to control precisely the calorific value as a whole. Thus, the temperature of the heating face 11a may not be made even.

The following will describe the expression (1), giving examples thereof.

In the ceramic heater 10 in FIG. 1, the total number n of the circuits of the resistance heating elements 12 is 8, which is the sum of: 4 in the resistance heating elements 12a to 12d in the outermost periphery, plus 4 in the resistance heating elements 12e to 12h in the inner portion of them.

In case where the diameter of the ceramic substrate is 200 (mm) or more, 210 (mm) or more, or 300 (mm) or more, the total circuit number is desirably 3 or more, 4 or more, or 7 or more, respectively.

When it is assumed that the diameter of the ceramic substrate 11 is 300 (mm), the relation holds: n $\geqq$ 3.2. That is, it is sufficient that the total circuit number is 4 or more. Thus, the ceramic heater 10 satisfies the above-mentioned expression (1).

When it is assumed that the diameter of the ceramic substrate 11 is 500 (mm), the relation holds: n $\geqq$ 8.6. That is, it is necessary that the total circuit number is 9 or more. Thus, the ceramic heater 10 does not satisfy the above-mentioned expression (1). As a result, it can be understood that the circuits needs to be divided to smaller circuits.

In other words, in order to satisfy the expression (1), it is necessary that the total circuit number of the resistance heating elements is made larger as the diameter of the ceramic substrate becomes larger.

It is also desired that the difference in the number of the circuits of the resistance heating elements formed in the outermost periphery and the number of the circuits of the resistance heating elements in the inner portion of them is within $\pm 1$. If the number of the circuits in the outermost periphery is extremely large, the number of the circuits in the inner portion of them is small. Accordingly, it is difficult to control calorific value precisely in the inner portion of the ceramic substrate. If the number of the circuits in the outermost periphery is small, it is difficult to control temperature precisely in the peripheral portion.

In the first aspect of the present invention, the resistance heating elements may be formed on the surface (bottom face) of the ceramic substrate, or may be embedded in the ceramic substrate.

In case where the resistance heating elements are formed on the surface of the ceramic substrate 11, the following method is preferred: a method by applying a conductive paste containing metal particles to the surface of the ceramic substrate 11 to form a conductor containing paste layer having a given pattern, and firing this to sinter the metal particles at the surface of the ceramic substrate 11. If the metal particles are fused and adhered to each other and the metal particles and the ceramic are fused and adhered to each other in the sintering of the metal, the sintering is sufficient.

When the resistance heating elements are formed on the surface of the ceramic substrate 11, the thickness of the resistance heating elements is preferably from 1 to 30 $\mu$m and more preferably from 1 to 10 $\mu$m. When the resistance heating elements are formed inside the ceramic substrate 11, the thickness thereof is preferably from 1 to 50 $\mu$m.

When the resistance heating elements are formed on the surface of the ceramic substrate 11, the width of the resistance heating elements is preferably from 0.1 to 20 mm and more preferably from 0.1 to 5 mm. When the resistance heating elements are formed inside the ceramic substrate 11, the width of the resistance heating elements is preferably from 5 to 20 $\mu$m.

The resistance value of the resistance heating elements can be changed dependently on their width or thickness. The above-mentioned ranges are however most practical. The resistance value becomes larger as the resistance heating elements become thinner and narrower. The thickness and the width of the resistance heating elements become larger in case where the resistance heating elements are formed inside the ceramic substrate 11. The reason for this is as follows. When the resistance heating elements are formed inside, the distance between the heating face and the resistance heating elements becomes short so that the evenness of the temperature on the surface deteriorates. Thus, it is necessary to make the width of the resistance heating elements themselves larger. Since the resistance heating elements are formed inside, it is unnecessary to consider the adhesiveness to a nitride ceramic and the like. Therefore, it is possible to use a high melting point metal such as tungsten or molybdenum, or a carbide of tungsten or molybdenum, and the like. Thus, the resistance value can be made high. Therefore, the thickness itself may be made large in order to prevent disconnection and so on. For these reasons, the resistance heating elements are desirably set to the above-mentioned thickness and width.

By setting the position where the resistance heating element are formed in this way, heat generated from the resistance heating elements diffuses in the whole of the ceramic substrate while the heat is conducted. Thus, temperature distribution on the face for heating an object to be heated (a semiconductor wafer) is made even so that temperatures of respective parts of the object to be heated are made even.

The resistance heating elements may have a rectangular section or an elliptical section. They desirably have a flat section. In case of the section being flat, heat is more easily radiated toward the heating face. Thus, a temperature distribution on the heating face is not easily generated.

The aspect ratio (the width of the resistance heating element/the thickness of the resistance heating element) of the section is desirably from 10 to 5000.

Adjustment thereof into this range makes it possible to increase the resistance value of the resistance heating elements and keep the evenness of the temperature on the heating face.

In case where the thickness of the resistance heating elements is made constant, the amount of heat conduction toward the heating face of the ceramic substrate 11 becomes small if the aspect ratio is smaller than the above-mentioned range. Thus , a thermal distribution similar to the pattern of the resistance heating elements is generated on the heating face. On the other hand, if the aspect ratio is too large, the temperature of the portions just above the centers of the resistance heating elements becomes high so that a thermal distribution similar to the pattern of the resistance heating elements is generated on the heating face. Accordingly, if temperature distribution is considered, the aspect ratio of the section is preferably from 10 to 5000.

When the resistance heating elements are formed on the surface of the ceramic substrate 11, the aspect ratio is desirably from 10 to 200. When the resistance heating elements are formed inside the ceramic substrate 11, the aspect ratio is desirably from 200 to 5000.

The aspect ratio becomes larger in case where the resistance heating elements are formed inside the ceramic substrate 11. This is based on the following reason. If the resistance heating elements are formed inside, the distance between the heating face and the resistance heating elements becomes shorter so that temperature evenness on the surface deteriorates. It is therefore necessary to make the resistance heating elements themselves flat.

The position where the resistance heating elements of the first aspect of the present invention are formed with deviation inside the ceramic substrate 11 is desirably a position near a bottom face 11b opposite to a heating face 11a of the ceramic substrate 11 and within the area more than 50 % to 99 % of the distance from the heating face 11a to the bottom face 11b.

If the value is 50 % or less, the position is too near to the heating face so that temperature-dispersion is caused. Conversely, if the value is over 99 %, the ceramic substrate 11 itself warps to damage the semiconductor wafer.

In case where the resistance heating elements are formed inside the ceramic substrate 11, plural resistance heating element forming layers may be formed. In this case, the patterns of the respective layers are desirably in the state that any one of the resistance heating elements is formed on some layer so as to be complementary to each other and, as viewed from a position above the heating face, the patterns are formed in all areas. A preferred example of such a structure is a staggered arrangement.

The conductor containing paste is not particularly limited, and is preferably a paste comprising not only metal particles or a conductive ceramic for keeping conductivity but also a resin, a solvent, a thickener and so on.

The metal particles are preferably made of, for example, a noble metal (gold, silver, platinum or palladium), lead, tungsten, molybdenum, nickel and the like, and are more preferably made of a noble metal (gold, silver, platinum or palladium). These may be used alone but is desirably used in combination of two or more. This is because: these metals are not relatively easily oxidized, and have a resistance value sufficient for generating heat.

Examples of the conductive ceramic include a carbide of tungsten and molybdenum, and the like. These may be used alone or in combination of two or more.

The particle diameter of these metal particles or the conductive ceramic particle is preferably from 0.1 to 100 $\mu$m. If the particle diameter is too fine, that is, below 0.1 $\mu$m, they are easily oxidized. On the other hand, if the particle diameter is over 100 $\mu$m, they are not easily sintered so that the resistance value becomes large.

The shape of the metal particles may be spherical or scaly. When these metal particles are used, they may be a mixture of spherical particles and scaly particles.

In case where the metal particles are scaly or a mixture of spherical particles and scaly particles, metal oxides between the metal particles are easily retained and adhesiveness between the resistance heating elements and, for example, the nitride ceramic is made sure. Moreover, the resistance value can be made large. Thus, this case is profitable.

Examples of the resin used in the conductor containing paste include epoxy resins, phenol resins and the like. Examples of the solvent include isopropyl alcohol and the like. Examples of the thickener include cellulose and the like.

It is desired to add a metal oxide to the metal particles in the conductor containing paste and make the resistance heating element of a sintered body of the metal particles and the metal oxide, as described above. By sintering the metal oxide together with the metal particles in this way, the nitride ceramic or the carbide ceramic constituting the ceramic substrate can be closely adhered to the metal particles..

The reason why the adhesiveness to the nitride ceramic or the carbide ceramic by mixing the metal oxide is improved is unclear, but would be based on the following: the surface of the metal particles, or the surface of the nitride ceramic or the carbide ceramic is slightly oxidized so that an oxidized film is formed thereon. Pieces of this oxidized film are sintered and integrated with each other through the metal oxide so that the metal particles and the nitride ceramic or the carbide ceramic are closely adhered to each other.

A preferred example of the metal oxide is at least one selected from the group consisting of lead oxide, zinc oxide, silica, boron oxide ($B_2O_3$), alumina, yttria, and titania.

These oxides make it possible to improve adhesiveness of the metal particles to the nitride ceramic or the carbide ceramic without increasing the resistance value of the resistance heating elements.

When the total amount of the metal oxides is set to 100 parts by weight, the weight ratio of lead oxide, zinc oxide, silica, boron oxide ($B_2O_3$), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The weight ratio is preferably adjusted within the scope that the total thereof is not over 100 parts by weight.

By adjusting the amounts of these oxides within these ranges, particularly adhesion to the nitride ceramic can be improved.

The addition amount of the metal oxides to the metal particles is preferably 0.1 % or more by weight and less than 10 % by weight.

The area resistivity when the resistance heating elements are formed is preferably from 0.1 to 10 $\Omega/\square$. If the area resistivity is less than 0.1 $\Omega/\square$, unless the width of the pattern of the resistance heating elements must be made as superfine as about 0.1 to 1 mm to ensure calorific value. Therefore, disconnection is caused by a slight crack of the pattern, or the resistance value varies. If the area resistivity is over 10 $\Omega/\square$, the amount of the calorific value cannot be ensured unless the width of the resistance heating elements is made large. Consequently, the flexibility of pattern design is decreased so that it becomes difficult to make the temperature of the heating face even.

In case where the resistance heating elements are formed on the surface of the ceramic substrate 11, a metal covering layer 120 (reference to FIG. 2) is preferably formed on the surface of the resistance heating elements. The metal covering layer prevents a change in the resistance value based on oxidization of the inner metal sintered body. The thickness of the formed metal covering layer 120 is preferably from 0.1 to 10 $\mu$m.

The metal used when the metal covering layer 120 is formed is not particularly limited if the metal is a metal which is non-oxidizable. Specific examples thereof include gold, silver, palladium, platinum, nickel and the like. These may be used alone or in combination of two or more. Among these metals, nickel is preferred.

In the resistance heating element 12, a terminal for a connection to a power source is necessary. This terminal is fixed to the resistance heating element 12 through solder. Nickel prevents solder from being thermally diffused. An example of the connecting terminal is a terminal pin 33 made of koval.

In case where the resistance heating elements are formed inside the ceramic substrate 11, no coating is necessary since the surface of the resistance heating elements is not oxidized. In case where the resistance heating elements are formed inside the ceramic substrate 11, a part of the resistance heating elements may be exposed in the surface. It is allowable that conductor filled through holes for connecting the resistance heating elements are made in portions for the terminals and terminals are connected and fixed to the conductor filled through holes.

In case where the connecting terminals are connected, an alloy such as silver-lead, lead-tin or bismuth-tin can be used as a solder. The thickness of the solder layer is desirably from 0.1 to 50 $\mu$m. This is because this range is a range sufficient for maintaining connection based on the solder.

Desirably, the ceramic heater of the first aspect of the present invention is equipped with:

a temperature-measuring element for measuring the temperature of the ceramic substrate;
a control unit for supplying electric power to the resistance heating element composed of a plurality of circuits;
a memory unit for memorizing the data of a temperature measured by the temperature-measuring element; and
an operation unit for calculating electric power required for the resistance heating element from the temperature data measured by the temperature-measuring element,
the ceramic heater being constituted such that respectively different electric powers are supplied to the plurality of circuits of the resistance heating element.

Since the ceramic heater has the operation unit, electric powers necessary for the respective circuits of the heating elements can be precisely calculated on the basis of the measured-temperature results even if an abrupt temperature change (disturbance) arises. For this reason, the resistance heating elements can be controlled to desired setting temperatures.

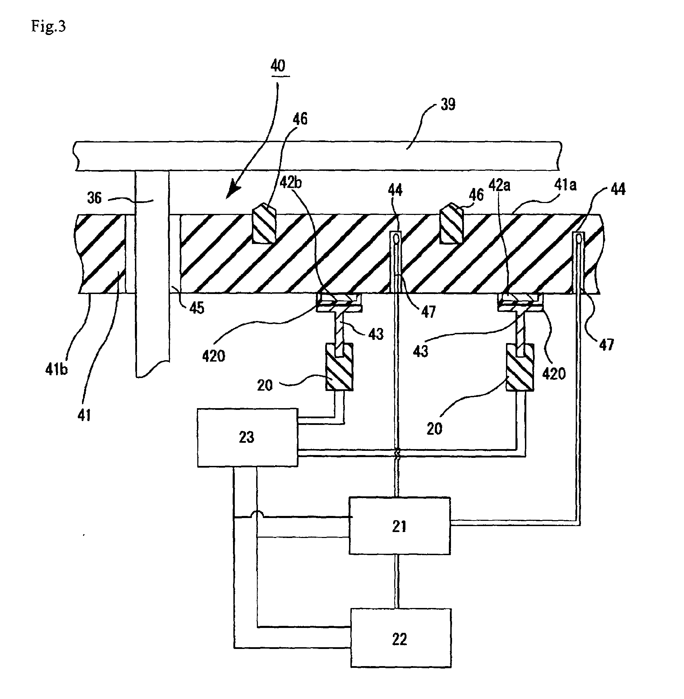

FIG. 3 is a block figure illustrating a ceramic heater 40, which is an example of the first aspect of the present invention.

In the ceramic heater 40, a ceramic substrate 41 is formed into a disc form. In order to perform heating in the manner that the temperature of the whole of a heating face 41a of the ceramic substrate 41 becomes even, resistance heating elements 42a which has a repeated pattern of circular arcs and which is formed by dividing concentric circles in the circumferential direction are arranged in the outermost periphery of a bottom face 41b of the ceramic substrate 41, so as to surround the periphery. In the inner portion of them, resistance heating elements 42b having a pattern of concentric circles-like are formed. External terminals 43, which will be terminals for input and output, are connected to both ends of the resistance heating element 42 (42a, 42b) through a metal covering layer 420. A socket 20 is attached to the external terminal 43. This socket 20 is connected to a control unit having a power source. In portions near the center, through holes 45, into which lifter pins 36 for supporting a semiconductor wafer 39 will be inserted, are made, and further bottomed holes 44, into which thermocouples 47 as temperature-measuring elements will be inserted, are made.

The bottomed holes 44 are made in the ceramic substrate 41 from the side of the bottom face 41b. The thermocouples 47 as temperature-measuring elements are fixed onto the bottom of the bottomed holes 44. The thermocouples 47 are connected to a memory unit 21 so that the temperatures of the respective thermocouples 47 are measured at intervals of a constant period and then the measured data are memorized. This memory unit 21 is connected to a control unit 23, and is further connected to an operation unit 22. On the basis of the data memorized in the memory unit 21, a voltage value for controlling and so on are calculated in the operation unit 22. On the basis of this, a certain voltage is applied to each of the resistance heating elements 42 from the control unit 23 so that the temperature of the heating face 41a can be made even.

The following will describe the action of the above-mentioned ceramic heater 40.

First, the control unit 23 is operated so that an electric power is supplied to the ceramic heater 40. As a result, the temperature of the heater plate 41 itself rises, but the surface temperature of the peripheral portion thereof becomes slightly low.

The data measured by the thermocouples 47 are temporarily stored in the memory unit 21. Next, the temperature data are sent to the operation unit 22. In the operation unit 22, temperature-differences AT among respective measured points are calculated and further data $\Delta W$ necessary for making the temperature on the heating surface 41a even are calculated.

For example, in the case where the temperature-difference $\Delta T$ is generated between the resistance heating element 42a and the resistance heating element 42b and the temperature of the resistance heating element 42a is lower, operations to obtain electric power data $\Delta W$ for making the $\Delta T$ to zero are run, this data is transmitted to the control unit 23 and an electric power based on this data is supplied to the resistance heating element 42a to raise the temperature thereof.

Regarding the algorithm for calculating the electric power, a method of calculating the electric power necessary for the rise in the temperature by utilizing the specific heat of the ceramic substrate 41 and the weight of the area to be heated is most simple. A correction coefficient originating from the pattern of the heating elements may be considered together with these factors. Alternatively, a temperature-rising test is beforehand performed on a specific heating element pattern, and functions among a temperature-measuring position, a supplying electric power and temperature are beforehand obtained. From these functions, the supplying electric power may be calculated. The applying voltage and time corresponding to the electric power calculated in the operation unit 22 are transmitted to the control unit 23. On the basis of these values, electric powers are supplied to the respective heating elements 42 by the control unit 23.

About the temperature-controlling method, it is desired to use the above-mentioned method. However, it is allowable to use, for example, a control comprising steps of: stopping the supply of an electric power to each of the circuits of the resistance heating elements when the temperature exceeds a given set temperature; and restarting the supply of the electric power when the temperature is below the given set temperature. Regarding the supplied electricity, it is allowable to use a control of supplying a constant electric power without calculating the electric power to be supplied. The temperature-controlling method is not limited to these methods.

The ceramic for making the ceramic heater 10 of the first aspect of the present invention is desirably a nitride ceramic or a carbide ceramic.

A nitride ceramic and a carbide ceramic have a smaller thermal expansion coefficient than those of metals, and a far higher mechanical strength than those of metals. Therefore, even if the thickness of the ceramic substrate 11 is made thin, the ceramic substrate is not warped or distorted by heating. Therefore, the ceramic substrate can be made thin and light. Furthermore, the thermal conductivity of the ceramic substrate 11 is high and the ceramic substrate itself is thin; therefore, the surface temperature of the ceramic substrate follows changes in the temperatures of the resistance heating elements promptly. That is, by varying voltage, electric current value and so on to change the temperatures of the resistance heating elements 12, the surface temperature of the ceramic substrate can be controlled.

Since a nitride ceramic or a carbide ceramic has a high thermal conductivity, a temperature-dispersion resulting from the resistance heating element pattern is easily generated. For this reason, the structure of the first aspect of the present invention functions more effectively thereof, as compared with an oxide ceramic.

Examples of the nitride ceramic include aluminum nitride, silicon nitride, boron nitride, titanium nitride and the like. These may be used alone or in combination of two or more.

Examples of the carbide ceramic include silicon carbide, zirconium carbide, titanium carbide, tantalum carbide, tungsten carbide and the like. These may be used alone or in combination of two or more.

Among these, aluminum nitride is the most preferred. This is because its thermal conductivity is highest, that is, 180 W/m · K and aluminum nitride has superior temperature-following property.

When a nitride ceramic, a carbide ceramic and the like is used as the ceramic substrate, an insulating layer may be formed if necessary. This is because: about a nitride ceramic, the volume resistivity thereof inclined to drop at high temperature by formation of solid-solution of oxygen and the like, and a carbide ceramic has an electric conductivity so far as the ceramic is not made into high purity. By forming the insulating layer, a short circuit is prevented between the circuits at high temperature or even if it contains impurities. Thus, temperature-controlling character can be ensured.

The above-mentioned insulating layer is desirably an oxide ceramic. Specifically, silica, alumina, mullite, cordierite, beryllia, and the like can be used.

Such an insulating layer may be formed: by spin-coating the ceramic substrate with a sol solution wherein an alkoxide is hydrolyzed and polymerized, and then drying and firing the solution; or by sputtering, CVD and the like. The surface of the ceramic substrate may be subjected to oxidization-treatment to deposit an oxide layer.

The insulating layer is desirably from 0.1 to 1000 μm. If the thickness thereof is less than 0.1 μm, insulation cannot be ensured. If the thickness is over 1000 μm, heat conductivity from the resistance heating elements to the ceramic substrate is hindered.

Furthermore, the volume resistivity of the insulating layer is desirably 10 or more times larger than that of the above-mentioned ceramic substrate (at the same measurement temperature). In the case of less than 10 times, a short circuit between the circuits can be prevented.

The thickness of the ceramic substrate 11 preferably is from 0.5 to 5 mm. If the thickness is thinner than 0.5 mm, the strength thereof drops so that the ceramic substrate is easily damaged. On the other hand, if the thickness is thicker than 5 mm, heat is not easily conducted so that heating efficiency deteriorates.

The diameter of the ceramic substrate 11 is desirably 200 mm or more. Since the temperature of the heating face more easily becomes uneven as the ceramic substrate has a larger diameter, the structure of the first aspect of the present invention functions effectively. A semiconductor wafer having a large diameter can be put onto the substrate having such a large diameter.

It is particularly desired that the diameter of the ceramic substrate is 12 inches (300 mm) or more, since such a ceramic substrate becomes the main stream of semiconductor wafers in the next generation.

It is desired that in the ceramic heater 10 of the first aspect of the present invention, the bottomed holes 14 are made, from the side opposite to the heating face 11a on which an object to be heated will be put to the heating face 11a, in the ceramic substrate 11, and that the bottoms of the bottomed holes 14 are formed nearer to the heating face 11a than the resistance heating elements 12 and temperature-measuring elements such as thermocouples 17 are fitted into the bottomed holes 14.

The distance between the bottoms of the bottomed holes 14 and the heating face 11a are desirably from 0.1 mm to 1/2 of the thickness of the ceramic substrate.

In this way, temperature-measuring positions are nearer to the heating face 11a than the resistance heating elements 12, so that the temperature of the semiconductor wafer can be more precisely measured.

If the distance between the bottoms of the bottomed holes 14 and the heating face 11a is less than 0.1 mm, heat is radiated so that temperature distribution is formed on the heating face 11a. If the distance is over 1/2 of the thickness, the ceramic substrate is easily affected by the temperature of the resistance heating elements so that temperature-control cannot be performed. Thus, temperature distribution is formed as well on the heating face 11a.

The diameter of the bottomed holes 14 desirably is from 0.3 to 5 mm. If the diameter is too large, heat-radiating property becomes large. If the diameter is too small, processability deteriorates so that the distance to the heating face 11a cannot be made even.

As illustrated in FIG. 1, the bottomed holes 14 are desirably arranged symmetrically to the center of the ceramic substrate 11 and arranged into a cross form. This is because the temperature of the entire heating face can be measured.

Examples of the temperature-measuring element include a thermocouple, a platinum temperature-measuring resistor, a thermistor and the like.

Examples of the thermocouple include K, R, B, S, E, J and T type thermocouples, as described in JIS-C-1602 (1980) and the like. Among these, the K type thermocouple is preferred.

It is desirable that the size of the connecting portions between the thermocouples and the metal wires is the same as or larger than a strand diameter of the metal wires, and is 0.5 mm or less. If the connecting portion is large, the heat capacity is large so that the responsibility is lowered. It is difficult to make the size of the connecting portion smaller than the diameter of the strand diameter.

The above-mentioned temperature-measuring elements may be bonded to the bottoms of the bottomed holes 14 with gold braze, silver braze and the like, or may be inserted into the bottomed holes 14 and sealed with a heat-resistant resin. The two may be used together.

Examples of the heat-resistant resin include thermosetting resins, particularly epoxy resin, polyimide resin, bismaleimide-triazine resin and the like. These resins may be used alone or in combination of two or more.

As the above-mentioned gold braze, desired is at least one selected from an alloy of 37 to 80.5% by weight of Au and 63 to 19.5% by weight of Cu, and an alloy of 81.5 to 82.5% by weight of Au and 18.5 to 17.5% by weight of Ni. These have a melting temperature of 900 °C or more, and are not easily melted in high temperature regions.

Examples of the silver braze that can be used include Ag-Cu alloys.

The following will describe a process for producing the ceramic heater of the first aspect of the present invention.

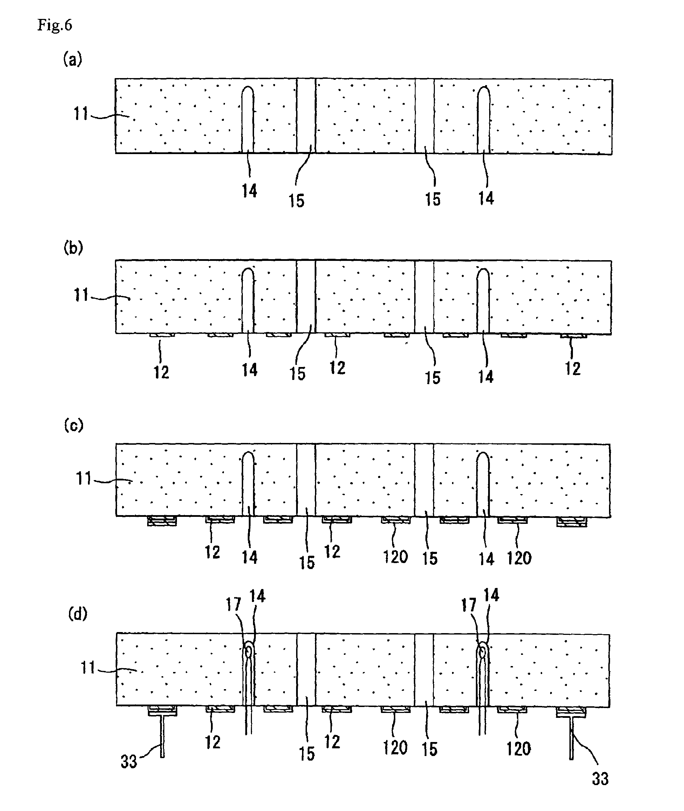

FIGs. 6(a) to 6(d) are sectional views schematically illustrating a process for producing a ceramic heater wherein resistance heating elements are formed on the bottom face of a ceramic substrate.

(1) Step of forming the ceramic substrate

If necessary, a sintering aid such as yttria ($Y_2O_3$) or $B_4C$ and the like, a compound containing Na or Ca, a binder and so on are blended with powder made of a nitride ceramic such as the above-mentioned aluminum nitride or a carbide ceramic to prepare a slurry. Thereafter, this slurry is made into a granular form by spray drying and the like. The granules are put into a mold and pressed to be formed into a plate form and the like form. Thus, a raw (green) formed body is produced.

Next, this raw formed body is heated and fired to be sintered. Thus, a plate made of the ceramic is produced. Thereafter, the plate is made into a given shape to produce the ceramic substrate 11. The shape of the raw formed body may be such a shape that the sintered body can be used as it is after the firing (FIG. 6(a)).

By heating and firing the raw formed body under pressure, the ceramic substrate 11 having no pores can be produced. It is sufficient that the heating and the firing are performed at sintering temperature or higher. The firing temperature is from 1000 to 2500 °C for nitride ceramics or carbide ceramics. The firing temperature is from 1500 to 2000 °C for oxide ceramics.

Next, the following are made in the ceramic substrate 11 if necessary: portions which become the through holes 15, into which lifter pins for supporting a semiconductor wafer will be inserted, and portions which becomes the bottomed holes 14, in which the temperature-measuring elements such as the thermocouples 17 will be embedded.

(2) Step of printing a conductor containing paste on the ceramic substrate

A conductor containing paste is a fluid comprising metal particles made of two or more noble metals and the like, a resin and a solvent, and has a high viscosity. This conductor containing paste is used to form a conductor containing paste layer in the outermost periphery of the ceramic substrate 11 by screen printing and the like in such a manner that the layer is composed of at least two circuits. Furthermore, a conductor containing paste layer which will be the different circuits is formed in the inner portion of the above-mentioned conductor containing paste layer printed in the outermost periphery.

It is desired at this time to satisfy the conductor containing paste layer that will be a resistance heating element pattern in which a relationship of the following expression (1) holds between the total number n of the circuits of the resistance heating elements 12 formed in the ceramic substrate 11 and the diameter r (mm) of the ceramic substrate 11:

$$n \geqq r^{1.94} \times 0.5 \times 10^{-4} \tag{1}$$

About the resistance heating element pattern, examples of the pattern formed in the outermost periphery of the ceramic substrate include a pattern of repeated circular arcs as illustrated in FIG. 1, and a pattern of repeated bending lines as illustrated in FIG. 4 and the like. Examples of the pattern formed in the inner portion of include a pattern of concentric circles and the like.

The conductor containing paste is desirably formed in the manner that a section of the resistance heating elements 12 after the firing is rectangular and flat.

(3) Firing of the conductor containing paste

The conductor containing paste layer printed on the bottom surface of the ceramic substrate 11 is heated and fired to remove the resin and the solvent and sinter the metal particles. Thus, the metal particles are baked onto the bottom surface of the ceramic substrate 11 to form the resistance heating elements 12 (FIG. 6(b)). The heating and firing temperature is preferably from 500 to 1000 °C.

If the above-mentioned oxides are added to the conductor containing paste, the metal particles, the ceramic substrate and the metal oxides are sintered to be integrated with each other. Thus, the adhesiveness between the resistance heating elements and the ceramic substrate is improved.

(4) Step of forming a metal covering layer

A metal covering layer 120 is desirably deposited on the surface of the resistance heating elements 12 (FIG. 6(c)). The metal covering layer 120 can be formed by electroplating, electroless plating, sputtering and the like. From the viewpoint of mass-productivity, electroless plating is optimal.

(5) Fitting of terminals and so on

Terminals (external terminals 33) for connection to a power source are fitted up to ends of the pattern of the resistance heating elements 12 with solder. Thermocouples 17 are fixed to the bottomed holes 14 with silver braze, gold braze and the like. The bottomed holes are sealed with a heat-resistant resin such as polyimide to finish the production of the ceramic heater (FIG. 6(d)).

About the ceramic heater of the first aspect of the present invention, electrostatic electrodes may be fitted thereto to make an electrostatic chuck, or a chuck top conductor layer may be deposited thereon to make a wafer prober.

Next, the second aspect of the present invention and the third aspect of the present invention will be described.

The second aspect of the present invention and the third aspect of the present invention are the same except the diameters of ceramic substrates and total numbers of circuits of resistance heating elements. First, different points between the two inventions and effects thereof will be described, and subsequently the second and third aspect of the present inventions will be described together.

The ceramic heater of the second aspect of the present invention is a ceramic heater comprising a disc shaped ceramic substrate having a diameter of 200 mm or more and a resistance heating element composed of two or more circuits formed: on a surface of the ceramic substrate; or inside the ceramic substrate,

wherein:

at least one of circuits of the resistance heating element is divided in the circumferential direction;
at least one of circuits of the resistance heating element contains a concentric circles-like or spiral pattern; and
further the total number of the circuits of the resistance heating element is 3 or more.

In the ceramic heater of the second aspect of the present invention, the diameter of the ceramic substrate is 200 mm or more, and the total number of the circuits of the resistance heating elements formed in the ceramic substrate is 3 or more.

Since the temperature of the heating face easily becomes uneven in the ceramic substrate having a diameter of 200 mm or more as described above, it is apprehended that peculiar points such as hot spots or cooling spots are locally generated. In order to control such peculiar points, it is necessary that the total number of the circuits of the resistance heating elements is 3 or more.

For the same reasons, it is desired that the total number of the circuits of the resistance heating elements is 7 or more in case where the diameter is 300 mm or more.

It is desired that the upper limit of the total number of the circuits of the resistance heating elements is 20.

If the total number is over 20, the resistance heating elements interfere with each other so that temperature-control becomes difficult.

The ceramic heater of the third aspect of the present invention is a ceramic heater comprising a disc shaped ceramic substrate and a resistance heating element composed of two or more circuits formed: on a surface of the ceramic substrate; or inside the ceramic substrate,

wherein:

at least one of circuits of the resistance heating element is divided in the circumferential direction;
at least one of circuits of the resistance heating element contains a concentric circles-like or spiral pattern; and
further a relationship of the following expression (2) holds between the total number n of the circuits of the resistance heating element and the diameter r (mm) of the ceramic substrate:

$$n \geqq r^{1.94} \times 10^{-4} \qquad (2).$$

Since the above-mentioned expression (2) holds between the total number n of the circuits of the resistance heating elements and the diameter r (mm) of the ceramic substrate in the ceramic heater of the third aspect of the present invention, the total number of the circuits of the resistance heating elements per the area of the heating face of the ceramic substrate is sufficiently large so that the area which any one of the circuits is supposed to heat is within an appropriate scope. As a result, dispersion in calorific value in any one of the circuits can be made small so that detailed control of the calorific value can be easily and precisely performed. As a result, for example, in boundary portions of the circuits low-temperature region such as cooling spots is prevented from being generated so that the temperature of the heating face of the ceramic heater can be made even. Accordingly, an object to be heated can be evenly heated so that the degree of curing of a resin to be cured on, for example, a semiconductor wafer can be made even and damage of the semiconductor can be prevented.

The following will describe the expression (2) showing the relationship between the diameter of the ceramic substrate and the total number of the circuits of the resistance heating elements in the third aspect of the present invention, giving examples thereof.

The following is assumed: a ceramic heater wherein resistance heating elements whose total circuit number is 6 are formed in a disc-form ceramic substrate.

In case where the diameter of the ceramic substrate is 210 (mm), this diameter is substituted for the expression (2) so that the following result is obtained: $n \geqq 3.2$. That is, it is sufficient that the total circuit number is 4 or more. This ceramic heater satisfies the expression (2).

On the other hand, if the diameter of the ceramic substrate 11 is 300 (mm), this diameter is substituted for the expression (2) so that the following result is obtained: $n \geqq 6.4$. That is, it is necessary that the total circuit number is 7 or more. This ceramic heater does not satisfy the expression (2). Thus, it is understood that the circuits needs to be further divided into small circuits.

In other words, in order to satisfy the expression (2), it is necessary that the total circuit number of the resistance heating elements is made larger as the diameter of the ceramic substrate becomes larger. In the ceramic heaters in which the diameter of the ceramic substrate is 200 (mm) or more, 210 (mm) or more, or 300 (mm) or more, the total circuit number is 3 or more, 4 or more, or 7 or more, respectively.

The ceramic heaters of the second and the third aspect of the present inventions have resistance heating elements being divided to two or more circuits in the circumferential direction. The reason why such a structure is adopted is that it is difficult to control the temperature of the heating face by circuits composed of concentric circles. By dividing the above-mentioned resistance heating elements to the two or more circuits in the circumferential direction and performing control in this way, unevenness in temperature distribution on the same circumference can be removed and the temperature of the face for heating an object to be heated (heating face) can be made even. Temperature easily becomes uneven particularly near the periphery because of heat radiation. Therefore, the resistance heating elements in the peripheral portion are desirably divided to two or more circuits in the circumferential direction.

In this case, it is unnecessary that the above-mentioned resistance heating elements being divided to the two or more circuits in the circumferential direction are present in the whole of the peripheral portion, and it is sufficient that they are present in an area of the peripheral portion.

The resistance heating elements being divided in the circumferential direction in the peripheral portion is desirably a pattern in the outermost periphery. This is because the temperature in the outermost periphery most easily becomes uneven and the temperature of this portion needs to be controlled. However, this fact does not deny that resistance heating elements are formed further outside the resistance heating elements being formed in the peripheral portion and divided in the circumferential direction.

The resistance heating elements being divided to the two or more circuits in the circumferential direction may be formed not only in the peripheral portion but also in the inner portion.

However, the ceramic heaters of the second and third aspect of the present inventions do not include any case in which resistance heating elements 92a to 92l are continuous in inner and outer portions and are circuits being divided in the circumferential direction (reference to FIG. 10), as seen in the ceramic heater in JP Kokai Hei 8-125001. This is because in ceramic heaters having such a structure, temperature becomes uneven in the diameter direction in the inner portion of its ceramic substrate and further a warp of the ceramic substrate is easily generated.

The amount of the warp of the ceramic substrate is desirably 60 µm or less.

If the warp amount is over 60 µm, dispersion in the distance between a semiconductor wafer, which is an object to be heated, and the ceramic substrate becomes large. Therefore, the semiconductor wafer cannot be evenly heated.

The method of heating the semiconductor wafer is classified into 2 kinds : one of which is a method by putting the semiconductor wafer directly on the ceramic substrate and heating the wafer, and the other of which is a method by separating the semiconductor wafer and the ceramic substrate 5 to 5000 µm apart from each other and heating the wafer. In either case, it is preferred that the warp amount of the ceramic substrate is 60 µm or less.

The ceramic heaters of the second and third aspect of the present inventions have a resistance heating element having a concentric circles-like or spiral pattern. By making the resistance heating element into such a pattern, unevenness in the temperature of the ceramic substrate in the diameter direction can be overcome and further a warp of the ceramic substrate can be prevented.

Particularly in the inner portion (portion inner from 1/2 of the radius of the ceramic substrate), unevenness in temperature is more easily generated in the diameter direction than in the circumferential direction; therefore, the circuit in the inner portion desirably has a concentric circles-like or spiral pattern.

In the inner portion of the ceramic substrate, the resistance heating element having the concentric circles-like or spiral pattern may be combined with the resistance heating elements being divided to the two or more circuits in the circumferential direction. This is because unevenness in the temperature of the inner portion of the ceramic substrate is overcome and further a warp of the ceramic substrate can be prevented.

It is therefore desired that in the ceramic heaters of the second and third aspect of the present invention the resistance heating elements being divided to the two or more circuits in the circumferential direction are formed in the peripheral portion and the resistance heating element having the concentric circles-like or spiral pattern is formed in the inner portion.

These resistance heating elements work together in integrated manner, whereby the temperature of the heating face of the ceramic substrate becomes even. Additionally, no warp is generated in the ceramic substrate so that the distance between the ceramic substrate and the semiconductor wafer becomes constant. As a result, the semiconductor wafer can be evenly heated.

In the ceramic heaters of the second and third aspect of the present inventions, it is possible to overcome unevenness on the heating face of the ceramic substrate generated particularly in the process in which temperature rises (transient property).

When it is assumed that the diameter of the ceramic substrate 11 is 210 (mm) in the ceramic heater of the third aspect of the present invention as illustrated in FIG. 1, it is necessary that the total number of the circuits is 4 or more as described above. However, in this ceramic heater 10, these resistance heating elements are composed of 8 circuits of resistance heating elements 12a to 12h. In this case, the above-mentioned expression (2) holds and the calorific value of the resistance heating elements can be precisely controlled so that the temperature of the heating face can be made even.

When it is assumed that the diameter of the ceramic substrate 51 is 210 (mm) in the ceramic heater of the third aspect of the present invention as illustrated in FIG. 4, it is necessary that the total number of the circuits is 4 or more as described above. In this ceramic heater 50, its resistance heating elements are composed of 8 circuits of resistance heating elements 52a to 52h. The above-mentioned expression (1) holds and the calorific value of the resistance heating elements can be precisely controlled so that the temperature of the heating face can be made even.

The total number of the circuits of the resistance heating elements formed in the ceramic heaters of the second and third aspect of the present inventions is 4 or more, or 7 or more in the ceramic heater wherein its ceramic substrate has a diameter of 210 (mm) or 300 (mm), respectively, as described above. The upper limit thereof is not particularly limited. However, in order to avoid complication of production steps, suppress production costs, and make the control of the resistance heating elements as easy as possible, the total number of the circuits of the resistance heating elements is desirably 10 or less in case where the diameter of the ceramic substrate is 210 (mm). The total number is desirably 20 or less in case where the diameter of the ceramic substrate is 300 (mm).

The pattern of the resistance heating elements is not particularly limited if at least one of the circuits is divided in the circumferential direction and comprises a concentric circles-like or spiral pattern. Examples thereof include a pattern wherein a pattern of repeated circular arcs and a pattern of concentric circles are used together, illustrated in FIG. 1; and a pattern wherein the resistance heating elements 52a to 52d, which are in a pattern of repeated bending lines, are formed in the outermost periphery and the resistance heating elements 52e to 52h, which are in a pattern of concentric circles, are formed in the inner portion of them, as illustrated in FIG. 4 and the like.

It is also possible to use, for example, a spiral pattern, a pattern of eccentric circles, or a pattern of repeated bending lines. These may be combined with each other, and these may be combined with the pattern illustrated in FIG. 1 or 4.

Particularly desired is a pattern wherein resistance heating elements composed of two or more circuits in the circumferential direction are arranged in the outermost periphery of the ceramic substrate and further a resistance heating element composed of a different circuit is formed in the inner portion of the above-mentioned resistance heating elements being arranged in the outermost periphery, for example, the pattern wherein the pattern of the repeated circular arcs and the concentric circles-like pattern are used together, illustrated in FIG. 1, or the pattern wherein the pattern of the repeated bending lines and the concentric circles-like pattern are used together, as illustrated in FIG. 4. This is because more detailed control of calorific value can be performed in the peripheral portion of the ceramic substrate, which radiates more heat.

The pattern divided in the circumferential direction is a pattern formed in areas obtained by drawing plural lines from the center of the ceramic substrate to the periphery thereof and dividing the ceramic substrate by the lines. Usually, all of the areas preferably have the same size. The number of the divided areas is not limited to 4, as illustrated in FIG. 1. The number may be 2 or more, for example, 3 or 5. Usually, the number is desirably made larger as the size of the ceramic substrate becomes larger.

In FIGs. 1 and 4, the resistance heating elements 12a to 12d and 52a to 52d are resistance heating elements being arranged in the outermost periphery. Such resistance heating elements in the outermost periphery are desirably formed in the region of 90% or more of the length from the edge to the center. In the case of less than 90%, the region where the resistance heating elements is formed in the outermost periphery becomes too wide so that the temperature of the heating face is not easily controlled.

The ceramic heaters of the second and third aspect of the present inventions are used at 100 to 800 °C.

It is also desired that a difference between the number of the circuit of the resistance heating elements formed in the outermost periphery and the number of the circuit of the resistance heating elements in the inner portion of them is within ±1. If the number of the circuits in the outermost periphery is extremely large, the number of the circuits in the inner portion of them is small. Accordingly, it is difficult to control calorific value precisely in the inner portion of the ceramic substrate. If the number of the circuits in the outermost periphery is small, it is impossible to control temperature precisely in the peripheral portion.

As illustrated in FIG. 3, in the ceramic heater 40, the ceramic substrate 41 is formed into a disc form and the resistance heating elements 42 are formed on the bottom face 41b of the ceramic substrate 41.

In order to perform heating in the manner that the temperature of the whole of the heating face 41a of the ceramic substrate 41 becomes even, resistance heating elements 42a which has the pattern of repeated circular arcs and which is formed by dividing concentric circles in the circumferential direction are arranged in the outermost periphery of the bottom face 41b of the ceramic substrate 41, so as to surround the periphery. In the inner portion of them, resistance heating elements 42b having the pattern of concentric circles are formed.

In the ceramic heater of the third aspect of the present invention, when it is assumed that the diameter of the ceramic substrate 41 is 210 (mm), it is sufficient that the number of the circuits n is 4 or more as described above. In the ceramic heater 40, the same pattern as in the ceramic heater illustrated in FIG. 1 is formed. The total circuit number thereof is 8, and the relationship of the expression (2) is satisfied.

In the ceramic heater of the third aspect of the present invention, the diameter of the ceramic substrate 11 is desirably 200 mm or more. Since the temperature of the heating face more easily becomes uneven as the diameter of the ceramic substrate is larger, the structure of the present invention functions effectively. A semiconductor wafer having a large diameter can be put onto the substrate having such a large diameter.

It is particularly desired that the diameter of the ceramic substrate is 12 inches (300 mm) or more. Such a ceramic substrate becomes the main stream of semiconductor wafers in the next generation.

In the ceramic heaters of the second and third aspect of the present inventions, the structures of their resistance heating elements, ceramic substrate, bottomed holes, and temperature-measuring elements and so on, other than the above-mentioned structures, are the same as in the case of the ceramic heater of the first aspect of the present invention. The explanation thereof is omitted.

Next, the process for producing the ceramic heaters of the second and third aspect of the present inventions will be described on the basis of FIGs. 6(a) to (d).

In the process for producing the ceramic heaters of the second and third aspect of the present inventions, steps other than the step (2) of printing a conductor containing paste on the ceramic substrate are the same as the process for producing the ceramic heater of the first aspect of the present invention. Therefore, the explanation of the step (1) of forming the ceramic substrate, the step (3) of firing the conductor containing paste, the step (4) of forming a metal covering layer, and the step (5) of setting up terminals and so on is omitted. Thus, the step (2) will be described in detail.

(2) the step of printing the conductor containing paste onto the ceramic substrate

The conductor containing paste is a fluid comprising metal particles comprising two or more noble metals and the like, a resin and a solvent, and has a high viscosity. With this conductor containing paste, screen printing is used to form a conductor containing paste layer, which will be a resistance heating element pattern wherein the following expression (2) holds between the total number n of the circuits of the resistance heating elements 12 formed on the ceramic substrate 11 and the diameter r (mm) of the ceramic substrate 11.

$$n \geqq r^{1.94} \times 10^{-4} \qquad (2)$$

It is desired at this time that the conductor containing paste layer is formed in such a manner that the conductor containing paste layer which will be at least two circuits being divided in the circumferential direction is formed in the outermost periphery of the ceramic substrate 11 and further the conductor containing paste layer which will be a different circuit is formed in the inner portion of the above-mentioned conductor containing paste layer printed in the outermost periphery. Examples of the resistance heating element pattern formed in the outermost periphery include the pattern of repeated circular arcs illustrated in FIG. 1 and the pattern of repeated bending lines in FIG. 4 and the like. The pattern formed in the inner portion of it may be, for example, a pattern of concentric circles and the like.

The conductor containing paste layer is desirably formed in the manner that a section of the resistance heating elements 12 after the firing will be rectangular and flat.

On the ceramic heaters of the second and third aspect of the present inventions, electrostatic electrodes may be disposed thereto to make an electrostatic chuck, or a chuck top conductor layer may be deposited thereon to make a chuck top plate for a wafer prober.

Best Modes for Carrying out the Invention

The present invention will be described in more detail hereinafter.

(Example 1) Production of a ceramic heater made of aluminum nitride (reference to FIGs. 1 and 2)

(1) A composition made of 100 parts by weight of aluminum nitride powder (average particle diameter: 1.1 μm), 4 parts by weight of yttria (average particle diameter: 0.4 μm), 12 parts by weight of an acrylic binder and an alcohol was subjected to spray-drying to make granular powder.

(2) Next, this granular powder was put into a mold and formed into a flat plate form to obtain a raw (green) formed body.

(3) The raw formed body subjected to the above-mentioned working treatment was hot-pressed at 1800 °C and a pressure of 20 MPa to obtain a nitride aluminum plate having a thickness of 3 mm.

Next, this plate was cut out into a disk having a diameter of 310 mm to prepare a plate (ceramic substrate) 11 made of the ceramic.

This formed body was drilled to make portions which would be through holes 15 into which lifer pins for supporting a semiconductor wafer would be inserted, and portions (diameter: 1.1 mm, depth: 2 mm) which would be bottomed holes 14 into which supporting pins for supporting thermocouples and the wafer would be embedded (FIG. 6(a)).

(4) A conductor containing paste was printed on the heater plate 11 obtained in the step (3) by screen printing. As patterns of the printing, a pattern of repeated circular arcs obtained by dividing concentric circles in the circumferential direction was formed in the outermost periphery, and a pattern of concentric circles was formed inner portion of it, as illustrated in FIG. 1.

The total number of circuits in the patterns was set to 8.

The pattern divided in the circumferential direction was formed in the portion outer from 1/2 of the radius of the ceramic substrate.

This is the number set to satisfy the following expression (1) between the total number n of the circuits of the resistance heating elements 12 formed on the ceramic substrate 11 and the diameter r (mm) of the ceramic substrate 11.

$$n \geqq r^{1.94} \times 0.5 \times 10^{-4} \tag{1}$$

The conductor containing paste was Solvest PS603D made by Tokuriki Kagaku Kenkyu-syo, which is used to form plated through holes in printed circuit boards.

This conductor containing paste was a silver-lead paste and contained 7.5 parts by weight of oxides made of lead oxide (5% by weight), zinc oxide (55% by weight), silica (10% by weight), boron oxide (25% by weight) and alumina (5% by weight) per 100 parts by weight of silver. The silver particles had an average particle diameter of 4.5 μm, and were scaly.

(5) Next, the ceramic substrate 11 on which the conductor containing paste was printed was heated and fired at 780 °C to sinter silver and lead in the conductor containing paste and bake them onto the ceramic substrate 11. Thus, resistance heating elements 12 were formed (FIG. 6(b)).

The silver-lead resistance heating elements 12 had a thickness of 5 μm, a width of 2.4 mm and an area resistivity of 7.7 mΩ/□.

(6) The ceramic substrate 11 formed in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) having a

thickness of 1 μm on the surface of the silver-lead resistance heating elements 12 (FIG. 6(C)).

(7) A silver-lead solder paste (made by Tanaka Kikinzoku Kogyo Co.) was printed by screen printing on portions to which terminals for attaining connection to a power source would be attached, to form a solder layer.

Next, external terminals 33 made of koval were put on the solder layer and heated at 420 °C for reflow to attach the external terminals 33 onto the surface of the resistance heating elements 12.

(8) Thermocouples for controlling temperature were fitted into the bottomed holes 14 and a ceramic adhesive agent (Aron ceramic, made by Toagosei Co., Ltd.) was buried therein. Thus, the thermocouples were fixed thereto so as to obtain a ceramic heater 10 (FIG. 6(d)). Furthermore, a temperature-adjusting equipment (E5ZE, made by Omron Corp.) having a control unit having a power source, a memory unit and an operation unit was prepared. Wiring from the control unit 23 was connected to the ceramic heater 10 through the external terminals 33. Furthermore, wiring from the thermocouples 17 was connected to the memory unit 21 to finish the production of the ceramic heater 10. (Examples 2) Production of a ceramic heater (reference to FIG. 4) made of aluminum nitride.

A ceramic heater 50 was produced and the above-mentioned temperature-adjusting equipment was connected in the same manner as in Example 1 except that when the conductor containing paste was printed on the ceramic substrate by screen printing, as patterns of the printing a pattern of repeated bending lines formed in the outermost periphery and divided in the circumferential direction and a pattern of concentric circles in the inner portion of it were formed as illustrated in FIG. 4.

However, the pattern of the repeated bending lines actually had a narrower interval therein than the pattern illustrated in FIG. 4. Therefore, the number of the repeated was more and the width thereof was also wider.

The total number of circuits in the patterns was set to 8.

This is the number set to satisfy the relationship of the above-mentioned expression (1) between the total number n of the circuits of the resistance heating elements 52 formed on the ceramic substrate 51 and the diameter r (mm) of the ceramic substrate 51.

(Example 3) Production of a ceramic heatermade of silicon carbide

A ceramic heater made of silicon carbide was produced and the above-mentioned temperature-adjusting equipment was connected in the same manner as in Example 1 except that silicon carbide (Diasic C-1000, made by Yakushima Denko.Co) having an average diameter of 1.1 μm was used, sintering temperature was set to 1900 °C, and the surface of the resultant ceramic substrate was fired at 1500 °C for 2 hours to form a $SiO_2$ layer having a thickness of 1 μm on the surface.

(Example 4) Production of a ceramic heater made of aluminum nitride

A ceramic heater made of silicon carbide was produced and the above-mentioned temperature-adjusting equipment was connected in the same manner as in Example 1 except that the total number of the circuits of the patterns of the resistance heating elements was set to 6: that is, 4 in the pattern of the repeated circular arcs which is divided in the circumferential direction and formed in the outermost periphery, plus 2 in the pattern of the concentric circles in the inner portion of it.

This is a value set not to satisfy the relationship of the above-mentioned expression (1) between the total number n of the circuits of the resistance heating elements formed on the ceramic substrate and the diameter r (mm) of the ceramic substrate.

(Example 5) Production of a ceramic heater (reference to FIG. 9) made of aluminum nitride

A ceramic heater made of silicon carbide was produced and the above-mentioned temperature-adjusting equipment was connected in the same manner as in Example 1 except that when the conductor containing paste was printed on the ceramic substrate by screen printing, a pattern divided into 2 in the circumferential direction was formed as the pattern of the printing in the inner portion of the ceramic substrate, as illustrated in FIG. 9.

The total number of circuits in the patterns was set to 9.

This is the number set to satisfy the relationship of the above-mentioned expression (1) between the total number n of the circuits of the resistance heating elements 12 formed on the ceramic substrate 81 and the diameter r (mm) of the ceramic substrate 81.

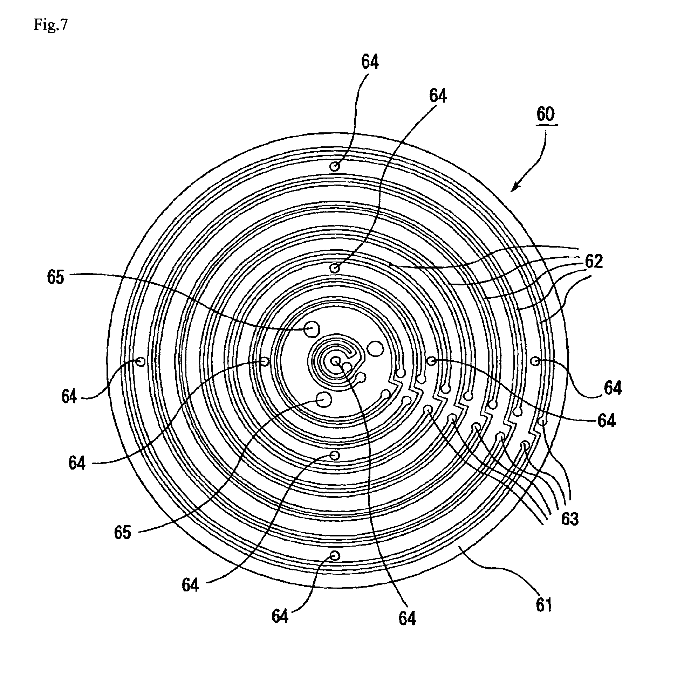

(Comparative Example 1) Production of a ceramic heater (reference to FIG. 7) made of aluminum nitride

A ceramic heater 60 was produced and the above-mentioned temperature-adjusting equipment was connected in the same manner as in Example 1 except that when the conductor containing paste was printed on the ceramic substrate by screen printing, a pattern of concentric circles-like was formed as the pattern of the printing as illustrated in FIG. 7.

The total number of circuits in the patterns was set to 8.

This is the number set to satisfy the relationship of the above-mentioned expression (1) between the total number n of the circuits of the resistance heating elements 62 formed with the ceramic substrate 61 and the diameter r (mm) of the ceramic substrate 61.

(Comparative Example 2) Production of a ceramic heater made of aluminum nitride

A ceramic heater made of aluminum nitride was produced and the above-mentioned temperature-adjusting equipment was connected in the same manner as in Example 1 except that the pattern of the resistance heating elements was made in the same manner as in Example 1 other than the fact that the total number of circuits was set to 3, circuits being divided into 2 in the circumferential direction were formed in the outer portion and a spiral pattern was formed in the inner portion. The production process thereof was used in the same as in Example 1.

This is a value set not to satisfy the relationship of the above-mentioned expression (1) between the total number n of the circuits of the resistance heating elements formed on the ceramic substrate and the diameter r (mm) of the ceramic substrate.

(Comparative Example 3) Production of a ceramic heater made of aluminum nitride (reference to FIG. 10)

A ceramic heater was produced and the above-mentioned temperature-adjusting equipment was connected in the same manner as in Example 1 except that the pattern of the resistance heating elements was formed to have a structure in which the inner portion and outer portion of the ceramic substrate were continuous and which was divided in the circumferential direction (reference to FIG. 10) as described in JP Kokai Hei 8-125001, and the total number of the circuits was set to 12.

This was a ceramic heater wherein the relationship of the above-mentioned expression (1) was satisfied between the total number n of the circuits of the resistance heating elements formed on the ceramic substrate and the diameter r (mm) of the ceramic substrate but no concentric circles-like or spiral pattern was formed.

(Test Example 1)

A ceramic heater was produced and the above-mentioned temperature-adjusting equipment was connected in the same manner as in Comparative Example 1 except that the diameter of the ceramic substrate was set to 150 mm.

This was a ceramic heater wherein the relationship of the above-mentioned expression (1) was satisfied between the total number n of the circuits of the resistance heating elements formed on the ceramic substrate 61 and the diameter r (mm) of the ceramic substrate but a pattern having no circuits which is divided in the circumferential direction was formed.

(Example 6) Production of a ceramic heater made of aluminum nitride (reference to FIGs. 1 and 2)

(1) A composition made of 100 parts by weight of aluminum nitride powder (average particle diameter: 1.1 μm), 4 parts by weight of yttria (average particle diameter: 0.4 μm), 12 parts by weight of an acrylic binder and an alcohol was subjected to spray-drying to make granular powder.

(2) Next, this granular powder was put into a mold and formed into a flat plate form to obtain a raw (green) formed body.

(3) The raw formed body subjected to the above-mentioned working treatment was hot-pressed at 1800 °C and a pressure of 20 MPa to obtain a nitride aluminum plate having a thickness of 3 mm.

Next, this plate was cut out into a disk having a diameter of 310 mm to prepare a plate shaped body (ceramic substrate) 11 made of the ceramic.

This formed body was drilled to make portions which would be through holes 15 into which lifer pins for supporting a semiconductor wafer would be inserted, and portions (diameter: 1.1 mm, depth: 2 mm) which would be bottomed holes 14 into which thermocouples be embedded (FIG. 6(a)).

(4) A conductor containing paste was printed on the heater plate 11 obtained in the step (3) by screen printing. In this way, a conductor containing paste layer was formed so that the total number of circuits of the resistance heating elements 12 would be 8.

This is the number set to satisfy the relationship of the following expression (2) between the total number n of the circuits of the resistance heating elements 12 formed on the ceramic substrate 11 and the diameter r (mm) of the ceramic substrate 11.

$$n \geqq r^{1.94} \times 10^{-4} \qquad (2)$$

In this case, $n \geqq 6.8$

As patterns of the printing, a pattern of repeated circular arcs formed in the outermost periphery by dividing concentric circles in the circumferential direction, and a pattern of concentric circles in the inner portion of it were formed as illustrated in FIG. 1.

The conductor containing paste was Solvest PS603D made by Tokuriki Kagaku Kenkyu-syo, which is used to form plated through holes in printed circuit boards.

This conductor containing paste was a silver-lead paste and contained 7.5 parts by weight of oxides made of lead oxide (5% by weight), zinc oxide (55% by weight), silica (10% by weight), boron oxide (25% by weight) and alumina (5% by weight) per 100 parts by weight of silver. The silver particles had an average particle diameter of 4.5 μm, and were scaly.

(5) Next, the ceramic substrate 11 on which the conductor containing paste was printed was heated and fired at 780 °C to sinter silver and lead in the conductor containing paste and bake them onto the ceramic substrate 11. Thus, resistance heating elements 12 were formed (FIG. 6(b)).

The silver-lead resistance heating elements 12 had a thickness of 5 μm, a width of 2.4 mm and an area resistivity of 7.7 mΩ/□.

(6) The ceramic substrate 11 formed in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) having a thickness of 1 μm on the surface of the silver-lead resistance heating elements 12 (FIG. 6(c)).

(7) A silver-lead solder paste (made by Tanaka Kikinzoku Kogyo Co.) was printed by screen printing on portions to which terminals for attaining connection to a power source would be attached, to form a solder layer.

Next, external terminals 33 made of koval were put on the solder layer and heated at 420 °C for reflow to attach the external terminals 33 onto the surface of the resistance heating elements 12.

(8) Thermocouples for controlling temperature were fitted into the bottomed holes 14 and a ceramic adhesive agent (Aron ceramic, made by Toagosei Co., Ltd.) was buried therein. Thus, the thermocouples were fixed thereto so as to obtain a ceramic heater 10 (FIG. 6(d)). Furthermore, a temperature-adjusting equipment (E5ZE, made by Omron Corp.) having a control unit having a power source, a memory unit and an operation unit was prepared. Wiring from the control unit 23 was connected to the ceramic heater 10 through the external terminals 33. Furthermore, wiring from the thermocouples 17 was connected to the memory unit 21 to finish the production of the ceramic heater 10. (Examples 7) Production of a ceramic heater (reference to FIG. 4) made of aluminum nitride.

A ceramic heater wherein resistance heating elements were formed on the bottom face of the ceramic substrate was produced and the above-mentioned temperature-adjusting equipment was connected in the same manner as in Example 6 except that when the conductor containing paste was printed on the ceramic substrate by screen printing, as patterns of the printing, a pattern of repeated bending lines formed in the outermost periphery and which is divided in the circumferential direction and a pattern of concentric circles in the inner portion of it were formed as illustrated in FIG. 4.

However, the pattern of the repeated bending lines actually had a narrower interval therein than the pattern illustrated in FIG. 4. Therefore, the number of the repeating was more and the width thereof was also wider.

The total number of circuits in the patterns was set to 8.

This is the number set to satisfy the relationship of the above-mentioned expression (2) between the total number n of the circuits of the resistance heating elements 52 formed on the ceramic substrate 51 and the diameter r (mm) of the ceramic substrate 51. In this case, also $n \geqq 6.8$.

(Example 8) Production of a ceramic heater made of silicon carbide

A ceramic heater made of silicon carbide was produced and the above-mentioned temperature-adjusting equipment was connected in the same manner as in Example 6 except that silicon carbide (Diasic C-1000, made by Yakushima Denko.Co) having an average diameter of 1.1 μm was used, sintering temperature was set to 1900 °C, and the surface of the resultant ceramic substrate was fired at 1500 °C for 2 hours to form a SiO$_2$ layer having a

thickness of 1 μm on the surface.

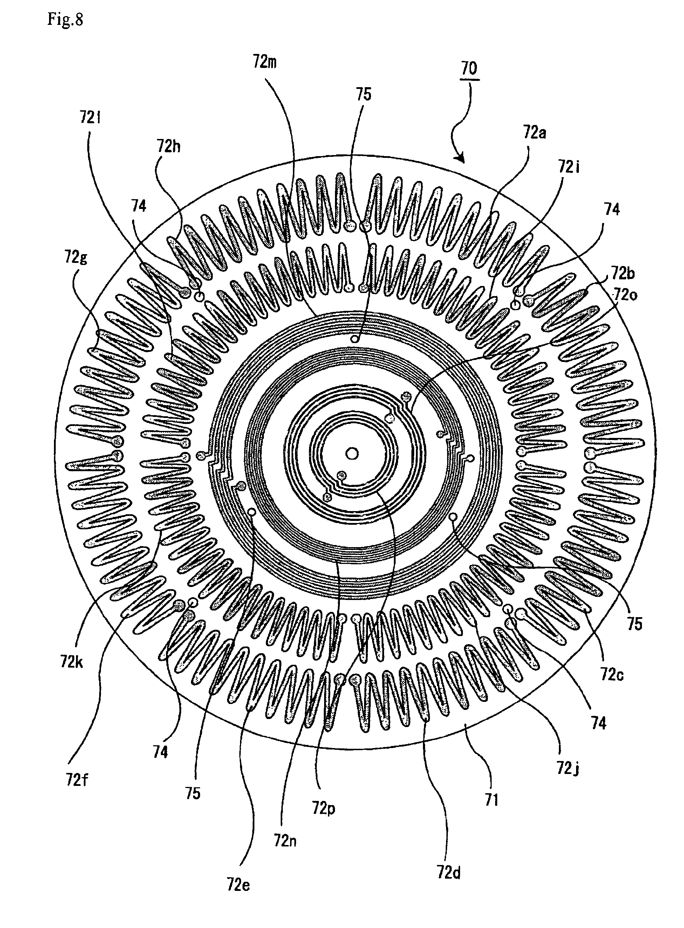

(Example 9) Production of a ceramic heater (reference to FIG. 8) made of aluminum nitride.

A ceramic heater 70 was produced and the above-mentioned temperature-adjusting equipment was connected in the same manner as in Example 6 except that when the conductor containing paste was printed on the ceramic substrate by screen printing, a pattern of concentric circles was formed as the pattern of the printing as illustrated in FIG. 8.
The total number of circuits in the patterns was set to 16.
This is the number set to satisfy the relationship of the above-mentioned expression (2) between the total number n of the circuits of the resistance heating elements 72 formed on the ceramic substrate 71 and the diameter r (mm) of the ceramic substrate 71.
FIG. 8 is a bottom view schematically illustrating a resistance heating element pattern in the ceramic heater of the second and third aspect of the present inventions. In this ceramic heater 70, resistance heating elements 72a to 72h composed of a pattern of repeated bending lines , which is divided in the circumferential direction, are formed in the outermost periphery of the ceramic substrate 71, and resistance heating elements 72i to 721 composed of a similar pattern of repeated bending lines are formed in the inner portion of it. Furthermore, in the inner portion of it resistance heating elements 72m to 72p composed of concentric circles are formed. The total number of circuits is 16.

(Example 10) Production of a ceramic heater (reference to FIG. 9) made of aluminum nitride

A ceramic heater was produced and the above-mentioned temperature-adjusting equipment was connected in the same manner as in Example 6 except that when the conductor containing paste was printed on the ceramic substrate by screen printing, a pattern divided into two pieces in the circumferential direction was formed as the pattern of the printing in the inner portion of the ceramic substrate, as illustrated in FIG. 9.
The total number of circuits in the patterns was set to 9.
This is the number set to satisfy the relationship of the above-mentioned expression (2) between the total number n of the circuits of the resistance heating elements 82 formed on the ceramic substrate 81 and the diameter r (mm) of the ceramic substrate 81.

(Comparative example 4) Production of a ceramic heater made of aluminum nitride (reference to FIG. 7)

A ceramic heater 60 was produced and the above-mentioned temperature-adjusting equipment was connected in the same manner as in Example 6 except that the pattern of the resistance heating elements was made to only a pattern of concentric circles-like (reference to FIG. 7) as described in JP Kokai Hei No. 11-40330.
This was a ceramic heater wherein the relationship of the above-mentioned expression (2) was satisfied between the total number n of the circuits of the resistance heating elements formed on the ceramic substrate and the diameter r (mm) of the ceramic substrate but no pattern of circuits being divided in the circumferential direction was formed.

(Comparative Example 5) Production of a ceramic heater made of aluminum nitride.

A ceramic heater made of aluminum nitride was produced and the above-mentioned temperature-adjusting equipment was connected in the same manner as in Example 6 except that regarding the pattern of the resistance heating elements the number of the circuits composed of the inner concentric circle pattern was set to 2 and the total number of the circuits was set to 6.
This is a value set not to satisfy the relationship of the above-mentioned expression (2) between the total number n of the circuits of the resistance heating elements formed on the ceramic substrate and the diameter r (mm) of the ceramic substrate 61.

(Comparative Example 6) Production of a ceramic heater made of aluminum nitride (reference to FIG. 10)

A ceramic heater was produced and the above-mentioned temperature-adjusting equipment was connected in the same manner as in Example 6 except that the pattern of the resistance heating elements was formed to have a structure in which the inner portion and outer portion of the ceramic substrate were continuous and which was divided in the circumferential direction (reference to FIG. 10) as described in JP Kokai Hei 8-125001, and the total number of the circuits was set to 12. This was a ceramic heater wherein the relationship of the above-mentioned expression (2) was satisfied between the total number n of the circuits of the resistance heating elements formed on the ceramic substrate and the diameter r (mm) of the ceramic substrate but no concentric circles-like or spiral pattern was formed.

(Comparative Example 7) Production of a ceramic heater made of aluminum nitride

A ceramic heater was produced and the above-mentioned temperature-adjusting equipment was connected in the same manner as in Example 6 except that the diameter of the ceramic substrate was set to 200 mm and the total number of the circuits was set to 2. This was a ceramic heater wherein the relationship of the above-mentioned expression (2) was not formed between the total number n of the circuits of the resistance heating elements formed on the ceramic substrate and the diameter r (mm) of the ceramic substrate.

(Test example 2)

A ceramic heater was produced and the above-mentioned temperature-adjusting equipment was connected in the same manner as in Comparative Example 4 except that the diameter of the ceramic substrate was set to 150 mm.
This was a ceramic heater wherein the relationship of the above-mentioned expression (2) was satisfied between the total number n of the circuits of the resistance heating elements formed on the ceramic substrate and the diameter r (mm) of the ceramic substrate but a pattern having no circuits being divided in the circumferential direction was formed.
The ceramic heaters according to Examples 1 to 10, Comparative Examples 1 to 7, and Test examples 1 and 2 obtained via the above-mentioned steps were evaluated based on the following indexes. The results are shown in Table 1.

Evaluation method

(1) Temperature distribution on the heating face at stationary time

A silicon wafer to which 17-point temperature-measuring elements (Pt resistor temperature-measuring elements) were fitted was used to measure in-plane temperature distribution. The temperature distribution shows a temperature difference between the highest temperature and the lowest temperature in the state that set temperature was 200 °C.

(2) In-plane temperature distribution at transient time

When temperature was raised from room temperature to 190 °C, distribution of in-plane temperature was measured. The temperature distribution shows a maximum value of a temperature difference between the highest temperature and the lowest temperature during the rise in the temperature.

(3) Warp amount of the ceramic substrate

The warp amount of the ceramic substrate was measured with a laser displacement measuring device (made by Keyence Corp.).

(4) Temperature distribution on the portion within 10 mm from the periphery of the ceramic substrate

A silicon wafer, the portion near periphery of which had the temperature-measuring elements at 10 points, was used to measure in-plane temperature distribution of the heating face. The temperature distribution shows a temperature difference between the highest temperature and the lowest temperature in the condition that set temperature was 200 °C.

(5) Temperature distribution on a silicon wafer

A silicon wafer was separated from the ceramic substrate by 100 μm. The temperature distribution was measured with a thermoviewer. The temperature distribution shows a temperature difference between the highest temperature and the lowest temperature in the condition that set temperature was 200 °C.

Table 1

| | In-plane temperature distribution at stationary time (°C) | In-plane temperature distribution at transient time (°C) | Warp amount of the ceramic substrate (μm) | In plane temperature distribution on the portion near periphery of the ceramic substrate (°C) | Temperature distribution on the silicon wafer (°C) |
|---|---|---|---|---|---|
| Example 1 | 0.5 | 5.0 | 20 | 0.3 | 0.5 |
| Example 2 | 0.5 | 5.2 | 25 | 0.3 | 0.5 |
| Example 3 | 0.4 | 5.0 | 22 | 0.2 | 0.4 |
| Example 4 | 0.5 | 5.1 | 23 | 0.3 | 0.5 |
| Example 5 | 0.3 | 4.0 | 10 | 0.3 | 0.3 |
| Comparative Example 1 | 5.2 | 8.3 | 25 | 5.2 | 5.3 |
| Comparative Example 2 | 8.1 | 10.1 | 25 | 5.0 | 8.0 |
| Comparative Example 3 | 5.0 | 8.0 | 65 | 0.5 | 10.0 |
| Test example 1 | 2.0 | 5.2 | 25 | 2.0 | 2.0 |
| Example 6 | 0.5 | 5.0 | 20 | 0.3 | 0.5 |
| Example 7 | 0.5 | 5.2 | 25 | 0.3 | 0.5 |
| Example 8 | 0.4 | 5.0 | 22 | 0.2 | 0.4 |
| Example 9 | 0.5 | 5.1 | 23 | 0.3 | 0.5 |
| Example 10 | 0.3 | 4.0 | 10 | 0.3 | 0.3 |
| Comparative Example 4 | 5.2 | 8.3 | 25 | 5.2 | 5.3 |
| Comparative Example 5 | 8.1 | 10.1 | 25 | 5.0 | 8.0 |
| Comparative Example 6 | 5.0 | 8.0 | 65 | 0.5 | 10.0 |
| Comparative Example 7 | 5.0 | 8.0 | 24 | 0.5 | 5.0 |
| Test example 2 | 2.0 | 5.2 | 25 | 2.0 | 2.0 |

As is evident from Table 1, in all of the ceramic heaters according to Examples, the in-plane temperature distributions at the stationary time and the transient time were small.

The reason for this can be considered as follows: by forming the resistance heating elements composed of circuits being divided in the circumferential direction in the outermost periphery of the ceramic substrate, in which temperature easily becomes unstable, more detailed control of calorific value became possible in the peripheral portion of the ceramic substrate so that the temperature of the heating face could be made even.

The above-mentioned reason can also be considered as follows. In the ceramic heaters according to Examples 6 to 10, the resistance heating elements were formed to satisfy the following expression (2) showing a relationship between the total number n of the circuits of the resistance heating elements formed on the ceramic substrate and the diameter r (mm) of the ceramic substrate. Therefore, the total number of the circuits of the resistance heating elements to the area of the heating face of the ceramic substrate became sufficiently large so that the area any one of the circuits was supposed to heat was within an appropriate scope. As a result, dispersion in calorific value in any one of the circuits could be made small so that detailed control of the calorific value could be precisely performed. Thus, the heating face became even.

$$n \geqq r^{1.94} \times 10^{-4} \tag{2}$$

On the other hand, in the ceramic heaters according to Comparative examples the in-plane temperature distributions at the stationary time and the transient time were larger than in the ceramic heaters according to Examples.

Particularly in the ceramic heaters of Comparative Example 2 and Comparative Example 5, the in-plane temperature distributions at the stationary time and the transient time were significantly large, and dispersion in the temperature of the peripheral portion of the ceramic heaters made its appearance significantly.

It can be considered that in the ceramic heater according to Comparative Example 2, by forming the resistance heating elements having the concentric circles-like pattern, it became difficult to perform detailed control of calorific value in the peripheral portion, in which temperature easily becomes unstable, so that the heating face became uneven.

It can also be considered that in the ceramic heater according to Comparative Example 5, no resistance heating elements composed of circuits the number of which satisfied the expression (2) were formed and the total number of the circuits of the resistance heating elements to the area of the heating face was small so that the area which any one of the circuits was supposed to heat was too wide, or as in the ceramic heater according to Comparative Example 4 the pattern of the resistance heating elements was not divided in the circumferential direction so that control was difficult, whereby it became difficult to precisely control calorific value as a whole and the heating face could not be evenly heated.

In Comparative Example 1, the in-plane temperature distributions at the stationary time and the transient time were smaller than in Comparative Example 2. The reason for this can be considered as follows. In the ceramic heater of Comparative Example 1, the resistance heating elements were formed to satisfy the following expression (1) showing an appropriate relationship between the total number n of the circuits of the resistance heating elements formed on the ceramic substrate and the diameter r (mm) of the ceramic substrate.

$$n \geqq r^{1.94} \times 0.5 \times 10^{-4} \tag{1}$$

The temperature distribution on the heating face of the ceramic heaters of Comparative Example 1 and Comparative Example 4 was equal to the temperature distribution in the peripheral portion thereof, that is, was generated by the temperature distribution in the peripheral portion. The temperature distribution on the heating face of the ceramic heaters according to Examples 1 to 10, Comparative Example 2 and Comparative Example 5 was different from the temperature distribution in the peripheral portion thereof, that is, was not generated by the temperature distribution in the peripheral portion but generated by a temperature difference between the peripheral portion and the inner portion. The reason for this can be considered as follows. The pattern of the resistance heating elements formed in the ceramic heaters according to Comparative Examples 1 and 4 were not divided in the circumferential direction so that the area supposed to be heated by the circuits formed in the peripheral portion, in which temperature distribution is easily generated, was too wide. Therefore, it became difficult to control the temperature of the peripheral portion, so that temperature distribution was generated in the peripheral portion.

Since the ceramic heaters according to Comparative Examples 3 and 6 had only the pattern wherein the resistance heating elements were divided in the circumferential direction, a warp of their ceramic substrates was large. Thus, any silicon wafer could not be evenly heated.

In the ceramic heater according to Comparative Example 7, the total amount of circuits was made to less than 3. It can be presumed that this fact made local temperature control impossible so that the temperature difference became large.

Furthermore, it can be understood from the ceramic heaters according to Test examples 1 and 2 that temperature distribution was small in the ceramic heater having the ceramic substrate whose diameter was 200 mm or less even if the ceramic heater had only the resistance heating elements of the concentric circles-like pattern. Therefore, it can be considered that such an adjustment as in the present invention is necessary in ceramic heaters having a ceramic substrate whose diameter is 200 mm or more.

Industrial Applicability

As described above, according to the ceramic heater of the present invention, detailed control of calorific value can be easily and precisely performed. Therefore, the temperature of the heating face of a semiconductor wafer can be made even. As a result, the degree of curing of a resin to be cured on the semiconductor wafer can be made even, and the damage of the semiconductor wafer can be prevented.

**Claims**

1.  A ceramic heater comprising a disc shaped ceramic substrate and a resistance heating element formed: on a surface of the ceramic substrate; or inside the ceramic substrate,
    wherein:

    the resistance heating element composed of two or more circuits being divided in the circumferential direction is arranged in the outermost periphery of said ceramic substrate; and
    further the resistance heating element composed of a different circuit is formed in the inner portion of said resistance heating element being arranged in the peripheral portion.

2.  The ceramic heater according to claim 1,
    wherein a relationship of the following expression (1) holds between the total number n of the circuits of the resistance heating element provided for said ceramic substrate and the diameter r (mm) of said ceramic substrate:

$$n \geqq r^{1.94} \times 0.5 \times 10^{-4} \tag{1}$$

3.  The ceramic heater according to claim 1 or 2,
    wherein said resistance heating element composed of a different circuit has a concentric circles-like or a spiral shape.

4.  The ceramic heater according to any of claims 1 to 3,
    wherein said resistance heating element composed of a different circuit is a combination of: a resistance heating element having a concentric circles-like or a spiral shape; and resistance heating elements being divided in the circumferential direction.

5.  A ceramic heater comprising a disc shaped ceramic substrate having a diameter of 200 mm or more and a resistance heating element composed of two or more circuits formed: on a surface of the ceramic substrate; or inside the ceramic substrate,
    wherein:

    at least one of circuits of said resistance heating element is divided in the circumferential direction;
    at least one of circuits of said resistance heating element contains a concentric circles-like or spiral pattern; and
    further the total number of the circuits of said resistance heating element is 3 or more.

6.  A ceramic heater comprising a disc shaped ceramic substrate and a resistance heating element composed of two or more circuits formed: on a surface of the ceramic substrate; or inside the ceramic substrate,
    wherein:

    at least one of circuits of said resistance heating element is divided in the circumferential direction;
    at least one of circuits of said resistance heating element contains a concentric circles-like or spiral pattern; and
    further a relationship of the following expression (2) holds between the total number n of the circuits of said resistance heating element and the diameter r (mm) of said ceramic substrate:

$$n \geqq r^{1.94} \times 10^{-4} \tag{2}$$

7. The ceramic heater according to any of claims 1 to 6,
   wherein said ceramic heater is used at a temperature of 100 to 800 °C.

8. A ceramic heater according to any of claims 1 to 7,
   wherein said-ceramic heater is equipped with:

   a temperature-measuring element for measuring the temperature of said ceramic substrate;
   a control unit for supplying electric power to said resistance heating element composed of a plurality of circuits;
   a memory unit for memorizing the data of a temperature measured by said temperature-measuring element; and
   an operation unit for calculating electric power required for said resistance heating element from said temperature data measured by said temperature-measuring element,
   said ceramic heater being constituted such that respectively different electric powers are supplied to the plurality of circuits of said resistance heating element.

9. The ceramic heater according to any of claims 1 to 8,
   wherein said ceramic substrate comprises a nitride ceramic or a carbide ceramic.

Fig.1

Fig.2

Fig.3

Fig.4

Fig.5

Fig.6

(a)

(b)

(c)

(d)

Fig.7

Fig.8

Fig.9

Fig.10

# INTERNATIONAL SEARCH REPORT

| International application No. |
| --- |
| PCT/JP01/02898 |

**A. CLASSIFICATION OF SUBJECT MATTER**
Int.Cl⁷ H05B3/10, H05B3/16, H05B3/20, H01L21/027

According to International Patent Classification (IPC) or to both national classification and IPC

**B. FIELDS SEARCHED**

Minimum documentation searched (classification system followed by classification symbols)
Int.Cl⁷ H05B3/10, H05B3/16, H05B3/20, H01L21/027, H05B3/68, H01L21/205

Documentation searched other than minimum documentation to the extent that such documents are included in the fields searched
Jitsuyo Shinan Koho 1926-1996 Toroku Jitsuyo Shinan Koho 1994-2001
Kokai Jitsuyo Shinan Koho 1971-2001 Jitsuyo Shinan Toroku Koho 1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP, 6-77148, A (NGK Insulators, Ltd.), 18 March, 1994 (18.03.94), Full text; Fig. 5 (Family: none) | 1-9 |
| Y | JP, 2-27715, A (Mitsubishi Electric Corporation), 30 January, 1990 (30.01.90), Full text; Fig. 1 (Family: none) | 1-9 |
| Y | JP, 11-40330, A (Ibiden Co., Ltd.), 12 February, 1999 (12.02.99), Full text; Fig. 1 (Family: none) | 1-9 |

☐ Further documents are listed in the continuation of Box C. ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 30 May, 2001 (30.05.01) | Date of mailing of the international search report 12 June, 2001 (12.06.01) |
| --- | --- |
| Name and mailing address of the ISA/ Japanese Patent Office | Authorized officer |
| Facsimile No. | Telephone No. |

Form PCT/ISA/210 (second sheet) (July 1992)